# EUROPEAN PATENT SPECIFICATION

(11) **EP 3 153 325 B1**
(45) Date of publication and mention of the grant of the patent: **28.04.2021**
(21) Application number: 15802399.4
(22) Date of filing: 02.03.2015
(51) Int. Cl.: B41N 1/14, B41C 1/10, B41F 3/34, B41M 1/06, B41N 1/06, G03F 7/00, H05K 3/12, B41N 1/00, B41N 3/00, B41N 3/03

(54) **PRINTING PLATE, METHOD FOR PRODUCING PRINTING PLATE, METHOD FOR MANUFACTURING FUNCTIONAL ELEMENT AND PRINTING APPARATUS**
DRUCKPLATTE, VERFAHREN ZUR HERSTELLUNG EINER DRUCKPLATTE, VERFAHREN ZUR HERSTELLUNG EINES FUNKTIONSELEMENTS UND DRUCKVORRICHTUNG
PLAQUE D'IMPRESSION, PROCÉDÉ DE PRODUCTION DE PLAQUE D'IMPRESSION, PROCÉDÉ DE FABRICATION D'ÉLÉMENT FONCTIONNEL ET APPAREIL D'IMPRESSION

(30) Priority: 05.06.2014 JP 2014116942
(43) Date of publication of application: 12.04.2017
(73) Proprietor: Dai Nippon Printing Co., Ltd., Tokyo 162-8001 (JP)
(72) Inventor: KANAZAWA, Shusuke, Tokyo 162-8001 (JP)
(74) Representative: Beck Greener LLP
(86) International application number: PCT/JP2015/056073
(87) International publication number: WO 2015/186386

(56) References cited:
- EP-A2- 1 713 311
- GB-A- 2 059 874
- JP-A- H1 152 555
- JP-A- S5 559 467
- JP-A- H08 234 424
- JP-A- S58 107 340
- JP-A- 2011 187 179
- JP-A- 2013 077 713

## Description

### Technical Field

The present disclosure relates to a printing plate for waterless planographic printing or intaglio printing and a producing method thereof, as well as a producing method for a functional element utilizing a printing plate for waterless planographic printing, and a printing apparatus.

### Background Art

Improvement in production technology for electronic devices has enabled forming a minute functional layer and contributed to popularize small and highly portable devices such as a smartphone and a tablet terminal.

Production of electronic devices is mainly conducted by a technique called photolithography. In photolithography, a protective layer is formed in a pattern on a functional layer that is formed on a substrate, and the functional layer exposed at an opening portion of the protective layer is removed by etching. Thus, photolithography is a method for forming a pattern by removing unnecessary portions, which is a subtractive method. In contrast, application of an additive method for directly forming a functional layer in a desired pattern has been advocated so as to increase efficiency of material utilization and to omit the production step drastically. The main measure for the additive method is printing, so that the field called printed electronics has drawn attention.

In the printed electronics, demanded is forming functional layers such as a wiring and a semiconductor layer to be a desired shape in micrometer order. In other words, higher resolution compared to a conventional print is demanded. Also, the demanded property is not satisfied with just that the visibility is made excellent by forming words and images beautifully like a conventional print, but also that the shapes of cross section and surface of the printed functional layer have to be in applicable condition to an electronic device. To satisfy these items, further improvement in printing technology is required.

There is a method called planographic printing as one of printing methods. Whereas intaglio and relief printing utilizes concaves and convexes on a plate, printing plate for planographic printing has a lipophilic image portion and a hydrophilic non-image portion. In recent years, as described in Patent Literature 1 for example, a waterless planographic printing plate using silicone rubber instead of dampening water is mainly produced.

Planographic printing utilizes wettability for patterning, and thus is suitable for ink with low viscosity. Ink with low viscosity is important in producing an electronic device by printing. The reason therefor is because the ink is suitable for forming a minute wiring, and a nano-particle-sized dispersion ink such as silver and copper with low resistance is generally low in viscosity.

In contrast, to make an ink suitable for gravure printing which is one kind of intaglio printing for example, it is necessary to increase the viscosity by mixing a binder polymer to a solution including metal particles. In this case, addition of the binder polymer lowers the purity of the metal inside the ink; thus the originally intended properties tend to be deteriorated; for example, resistance at the time of forming a wiring is increased. Accordingly, improvement in the pattern technique based on wet and rebound (cissing) of ink such as planographic printing is considered to greatly contribute to technological development in printed electronics.

In a printing method, transferability is one of the objects; for example, as described in Patent Documents 2 to 4, ink adhered to a printing plate is ideally completely transferred to a substrate for printing. This state is occasionally called simply "complete transfer". If incomplete transfer is repeatedly printed, remaining ink is accumulated in parts such as graves of a printing plate and a blanket for transferring; thus, resolution of the print is deteriorated. This is not an easily recognized problem in conventional printing on paper; the reason therefor is that ink sinks in paper and is easily transferred. However, deterioration in resolution stands out in cases such as printing on a plastic film which ink does not easily sink in. Also, in the case of complete transfer, upper surface of the printing plate filled with ink and the bottom surface reverses at the time of printing. This state is more advantageous compared to incomplete transfer in which ink is sheared in the middle way, since the surface of the print is smooth. It has been sufficient for conventional printing to satisfy human visual recognition; however, in printed electronics that gives electronic function to aprint, smoothness and shape of the surface are demanded in higher levels. The state to satisfy the demand may be formed by causing the complete transfer.

As a method to enable the complete transfer, Patent Documents 2 to 3 suggest use of a silicone blanket comprised of silicone rubber, and use of ink including predetermined solvent. According to Patent Documents 2 to 3, from the time ink is adhered to a silicone blanket to the time ink is transferred to a substrate for printing, the solvent in the ink is volatilized to increase viscosity of the ink; thus agglutination force of the ink is increased, and the solvent in the ink is permeated to the silicone blanket, so that the ink transferability from a printing plate to a substrate for printing may be improved.

On the other hand, in a lot of waterless planographic printing, as described in Patent Document 1 for example, a silicone rubber layer is a hydrophobic non-image portion that rebounds ink; an image portion that receives ink is constituted with a thermosensitive layer, and the thermosensitive layer is not silicone rubber. Accordingly, even in the case of using the ink including a predetermined solvent as described in Patent Documents 2 to 3, the solvent in the ink is not permeated into the thermosensitive layer which is the image portion; thus agglutination force of the ink may not be improved, so that the complete transfer of the ink is difficult. Consequently, planographic printing is favorable technology for usual printing, but has problems in producing an electronic device.

In contrast, Patent Document 5 suggests a printing plate for planographic printing including a non-image portion comprised of organosilicone layer and an image portion comprised of an organosilicone layer whose surface is lyophilized. In such a printing plate for planographic printing, the image portion is comprised of an organosilicone layer, so that the complete transfer is possible when using the ink including a predetermined solvent described in Patent Documents 2 to 3.

According to Patent Document 5, a protective layer is disposed in a pattern by using a photo resist on the organosilicone layer, subjected to a plasma treatment, and then the protective layer is removed to produce the printing plate for planographic printing. In other words, a photo resist is utilized in this method.

However, a problem in the above method is that pattern formation with high resolution is difficult in most of photo resists. That is, since the main solvent of a photo resist is mostly well permeable to silicone, i.e. propylene glycol monomethyl ether acetate and methyl ethyl ketone swellable in silicone; thus the protective layer is swelled in the manner that the solvent in the photo resist permeated to the organosilicone layer once at the time of forming a photo-resist film reversibly flows to the photo-resist side (protective layer side) after forming the photo-resist pattern; thereby, the pattern shape of the protective layer becomes defect. To avoid the defect, evaporation of the solvent in the photo-resist permeated into the organosilicone layer by heating at high temperature after coating the photo-resist may be considered; however, solubility to a developing solution at the time of developing the photo-resist is remarkably deteriorated in this case. Thus, the limit in resolution of a photo-resist formable by this method is approximately 50 µm. Accordingly, high-definition printing is difficult by the printing plate for planographic printing; application thereof is difficult for the use that requires refinement of patterns such as a circuit.

In addition, printing durability is also one of the objects for a printing method; planographic printing, as described in Patent Document 5, has a problem that ink adheres to a non-image portion at the time of continuous printing, which is called base staining. For the complete transfer, it can be said that using the ink including a solvent permeable in silicone as described in Patent Documents 2 to 3 is preferable. In the case of using such ink, in the printing plate for planographic printing described in Patent Document 5, the non-image portion is also constituted with an organosilicone layer, so that the organosilicone layer is swelled little by little by the solvent in the ink, in the manner that the ink repeatedly contacts with the surface of the printing plate for planographic printing. In the swelled state, property of the organosilicone layer in the non-image portion is deteriorated, and thus the ink is slightly adhered to the non-image portion. Only the minute base staining permitted in usual printing is not permitted in the application to an electronic device, since it may cause an electronic short circuit, for example.

In these manners, in printing techniques based on wet and rebound (cissing) by ink such as in planographic printing problems are deterioration in resolution due to permeation of the solvent in a photo-resist at the time of forming the printing plate, and base staining due to permeation of the solvent in the ink at the time of continuous printing.

### Citation List

### Patent Documents

Patent Document 1: Japanese Patent Application Laid-Open (JP-A) No. 2001-225565
Patent Document 2: JP-A No. 2011-187179
Patent Document 3: WO 2008/111484
Patent Document 4: JP-A No. 2013-77713
Patent Document 5: JP-A No. S55-59467

### Disclosure

### Technical Problem

The present disclosure has been made in view of the problems, and a main object thereof is to provide a printing plate with excellent transferability, printing durability, and resolution, a producing method for the printing plate, a producing method for a functional element utilizing the printing plate, and a printing apparatus.

### Solution to Problem

In order to achieve the object, an embodiment of the present invention provides a printing plate for waterless planographic printing or intaglio printing comprising: a substrate containing an elastic body swellable in a solvent in an ink, a hydrophobic solvent permeation preventing layer that is a non-image portion formed on the substrate in a pattern which includes a function of inhibiting permeation of a solvent in an ink, and a hydrophilic portion that is an image portion formed on a surface of the substrate at an opening portion of the hydrophobic solvent permeation preventing layer and higher in hydrophilicity than the hydrophobic solvent permeation preventing layer.

According to the embodiment of the present invention, the hydrophilic portion is a portion such that the substrate surface is hydrophilized, and the substrate contains the elastic body swellable in a solvent, so that the solvent in the ink adhered to the hydrophilic portion of the printing plate may be permeated to the hydrophilic portion when printing by the printing plate of the embodiment of the present invention, and thus agglutination force of the ink on the surface of the hydrophilic portion of the printing plate may be increased; thereby complete transfer is possible. Also, according to the embodiment of the present invention, the hydrophobic solvent permeation preventing layer includes a function of inhibiting permeation of a solvent so as to prevent the hydrophobic solvent permeation preventing layer from being swelled by the solvent in the ink, in the case of continuous printing by means of the printing plate of the embodiment of the present invention, and so as to prevent the ink from being adhered to the hydrophobic solvent permeation preventing layer surface; thus, occurrence of base staining may be inhibited. Also, on the occasion of producing the printing plate of the embodiment of the present invention, a hydrophilic portion may be formed in the manner by forming a resist pattern on the hydrophobic solvent permeation preventing layer, removing the hydrophobic solvent permeation preventing layer in a pattern by utilizing the resist pattern, and then hydrophilizing the substrate surface. Thereby, the solvent in the resist may be prevented from being permeated to the substrate so as to inhibit the shape defect of the resist pattern due to expansion of the resist pattern caused by leakage of the solvent in the resist permeated to the printing plate at the time of forming the resist, to the resist pattern. Accordingly, the resist pattern may be formed with high resolution and a minute hydrophilic portion may be formed. Therefore, the embodiment of the present invention enables improvement of transferability, printing durability, and resolution.

In the embodiment of the present invention, the elastic body is preferably silicone rubber, acrylic rubber, urethane rubber, fluoro rubber, polysulfide rubber, ethylene-propylene rubber, nitrile rubber, butyl rubber, chloroprene rubber, butadiene rubber, or styrene-butadiene rubber. These are favorable as the elastic body swellable in a solvent.

Also, in an embodiment of the present invention, a surface of the hydrophobic solvent permeation preventing layer side of the substrate may be flat. Also, in an embodiment of the present invention, the surface of the substrate may include a concave portion at the opening portion of the hydrophobic solvent permeation preventing layer. If the level difference between the hydrophobic solvent permeation preventing layer and the hydrophilic portion is small, the printing plate maybe a printing plate for planographic printing; if the level difference is large, the printing plate may be a printing plate for intaglio printing.

Also, an embodiment of the present invention provides a producing method for a printing plate for waterless planographic printing or intaglio printing comprising:
a hydrophobic solvent permeation preventing layer forming step of forming a hydrophobic solvent permeation preventing layer including a function of inhibiting permeation of a solvent in an ink on a substrate containing an elastic body swellable in a solvent in an ink; a resist pattern forming step of forming a resist pattern on the hydrophobic solvent permeation preventing layer; a removing and hydrophilizing step of removing the hydrophobic solvent permeation preventing layer at an opening portion of the resist pattern, and hydrophilizing the exposed substrate surface to form a hydrophilic portion; and a resist pattern peeling step of peeling the resist pattern; wherein the method allows a printing plate with the hydrophobic portion as an image portion and the hydrophobic solvent permeation preventing layer surface as a non-image portion to be obtained.

According to the embodiment of the present invention, the hydrophobic solvent permeation preventing layer includes a function of inhibiting permeation of a solvent so as to prevent the solvent in the resist from being permeated to the substrate by forming the resist pattern on the hydrophobic solvent permeation preventing layer. Thereby, the solvent in the resist permeated to the printing plate at the time of forming the resist pattern may be prevented from flowing backward, and thus the shape defect due to expansion of the resist pattern may be inhibited. Accordingly, the resist pattern may be formed with high resolution and a minute hydrophilic portion may be formed. Also, according to the embodiment of the present invention, the hydrophilic portion is formed by hydrophilizing the substrate surface, and the substrate contains the elastic body swellable in a solvent, so that a solvent in ink adhered to the hydrophilic portion of the printing plate may be permeated to the hydrophilic portion in the case of printing by the printing plate produced by the embodiment of the present invention, and agglutination force of the ink may be increased; thus complete transfer is possible. Also, on the occasion of continuous printing by using the printing plate produced by the embodiment of the present invention, the hydrophobic solvent permeation preventing layer is prevented from being swelled by the solvent in the ink so as to inhibit ink adhesion to the hydrophobic solvent permeation preventing layer surface; thus occurrence of base staining may be inhibited. Therefore, the embodiment of the present invention allows the printing plate with excellent transferability, printing durability, and resolution to be obtained.

In the embodiment of the present invention, the elastic body is preferably silicone rubber, acrylic rubber, urethane rubber, fluoro rubber, polysulfide rubber, ethylene-propylene rubber, nitrile rubber, butyl rubber, chloroprene rubber, butadiene rubber, or styrene-butadiene rubber. These are favorable as the elastic body swellable in a solvent.

Also, the producing method for a printing plate of an embodiment of the present invention preferably further comprises a pre-treating step of hydrophilizing the substrate surface before the hydrophobic solvent permeation preventing layer forming step. The reason therefor is to form a hydrophobic solvent permeation preventing layer with favorable adherence to a substrate. In this manner, when transferring ink by adhering the printing plate, to be produced by the embodiment of the present invention, to a substrate for printing, the hydrophobic solvent permeation preventing layer is prevented from being peeled off from the substrate, and thus a printing plate with high printing durability may be obtained.

Also, in an embodiment of the present invention, the removing and hydrophilizing step may comprise: a removing step of removing the hydrophobic solvent permeation preventing layer at the opening portion of the resist pattern and further removing the exposed substrate surface to form a concave portion on the substrate surface; and a hydrophilizing step of hydrophilizing the exposed substrate surface. If the level difference between the hydrophobic solvent permeation preventing layer and the hydrophilic portion is small, a printing plate for planographic printing may be obtained; if the level difference is large, a printing plate for intaglio printing may be obtained.

Further, an embodiment of the present invention provides a producing method for a functional element comprising: a printing plate preparing step of preparing a printing plate for waterless planographic printing comprising: a substrate containing an elastic body swellable in a solvent in an ink, a hydrophobic solvent permeation preventing layer that is a non-image portion formed on the substrate in a pattern and includes a function of inhibiting permeation of a solvent in an ink, and a hydrophilic portion that is an image portion formed on a surface of the substrate at an opening portion of the hydrophobic solvent permeation preventing layer and higher in hydrophilicity than the hydrophobic solvent permeation preventing layer; wherein a surface of the hydrophobic solvent permeation preventing layer side of the substrate is flat; a blanket preparing step of preparing a blanket including a second substrate that contains an elastic body swellable in a solvent and includes a hydrophilic region on the surface; a coating step of coating the hydrophilic region side surface of the blanket with a coating solution for forming functional layer; a first transferring step of transferring the coating solution for forming functional layer in the blanket to only the hydrophilic portion of the printing plate by making the blanket to contact with the printing plate via the coating solution for forming functional layer; and a second transferring step of forming a functional layer by transferring the coating solution for forming functional layer remaining in the blanket to a substrate for forming functional layer; wherein the hydrophilic region of the blanket is higher in hydrophilicity than the hydrophobic solvent permeation preventing layer of the printing plate, and is equal to or lower in hydrophilicity than the hydrophilic portion of the printing plate.

According to the embodiment of the present invention, usage of the blanket including the above described printing plate and predetermined hydrophilicity allows complete transfer of the coating solution for forming functional layer in both the first transferring step and the second transferring step. Thereby, printing with high resolution is possible.

In the embodiment of the present invention, the elastic body is preferably silicone rubber, acrylic rubber, urethane rubber, fluoro rubber, polysulfide rubber, ethylene-propylene rubber, nitrile rubber, butyl rubber, chloroprene rubber, butadiene rubber, or styrene-butadiene rubber. These are favorable as the elastic body swellable in a solvent.

Also, the producing method for a functional element of an embodiment of the present invention preferably comprises a removing step of transferring the coating solution for forming functional layer at the hydrophilic portion of the printing plate to a substrate for cleaning. Usage of the above described printing plate allows complete transfer of the coating solution for forming functional layer also in the removing step. Thereby, continuous printing is possible.

Further, an embodiment of the present invention provides a printing apparatus comprising: a printing plate for waterless planographic printing that comprises a substrate containing an elastic body swellable in a solvent in an ink, a hydrophobic solvent permeation preventing layer that is a non-image portion formed on the substrate in a pattern and includes a function inhibiting permeation of a solvent in a ink, and a hydrophilic portion that is an image portion formed on a surface of the substrate at an opening portion of the hydrophobic solvent permeation preventing layer and higher in hydrophilicity than the hydrophobic solvent permeation preventing layer; wherein a surface of the hydrophobic solvent permeation preventing layer side of the substrate is flat; a blanket including a second substrate that contains an elastic body swellable in a solvent and includes a hydrophilic region on the surface, and disposed so as to be capable of contacting with the printing plate; a coating machine for coating the hydrophilic region side surface of the blanket with an ink; a mounting member for printing that mounts a substrate for printing and is disposed so as to be capable of contacting with the blanket; and a mounting member for cleaning that mounts a substrate for cleaning and is disposed so as to be capable of contacting with the printing plate; wherein the hydrophilic region of the blanket is higher in hydrophilicity than the hydrophobic solvent permeation preventing layer of the printing plate, and is equal to or lower in hydrophilicity than the hydrophilic portion of the printing plate.

According to the embodiment of the present invention, the blanket including above-described printing plate and predetermined hydrophilicity is provided so as to allow complete transfer of the ink at the time of transferring the ink from the blanket to the hydrophilic portion of the printing plate, transferring the ink from the blanket to the substrate for printing, and transferring the ink from the hydrophilic portion of the printing plate to the substrate for cleaning. Thereby, printing with high resolution is possible, and continuous printing is also possible.

In the embodiment of the present invention, the elastic body is preferably silicone rubber, acrylic rubber, urethane rubber, fluoro rubber, polysulfide rubber, ethylene-propylene rubber, nitrile rubber, butyl rubber, chloroprene rubber, butadiene rubber, or styrene-butadiene rubber. These are favorable as the elastic body swellable in a solvent.

Also, in an embodiment of the present invention, the printing plate, the blanket, and the mounting member for cleaning are preferably in a roll shape; and the printing apparatus preferably further comprises a cleaning unit that includes the roll shape mounting member for cleaning, a first roll for feeding the substrate for cleaning which is long, and a second roll for taking up the substrate for cleaning. The reason therefor is to maintain the surface of the substrate for cleaning, to which the printing plate contacts, in clean condition always.

### Advantageous Effects of Disclosure

An embodiment of the present invention produces the effect such as to allow a printing plate with excellent transferability, printing durability, and resolution to be obtained.

### Brief Description of Drawings

FIG. 1 is a schematic sectional view illustrating an example of a printing plate of an embodiment of the present invention.
FIGS. 2A to 2E are process diagrams illustrating an example of a producing method for a printing plate of an embodiment of the present invention.
FIGS. 3A to 3C are process diagrams illustrating an example of a using method for a printing plate of an embodiment of the present invention.
FIG. 4 is a schematic sectional view illustrating another example of a printing plate of an embodiment of the present invention.
FIGS. 5A to 5F are process diagrams illustrating another example of a producing method for a printing plate of an embodiment of the present invention.
FIGS. 6A to 6C are process diagrams illustrating another example of a using method for a printing plate of an embodiment of the present invention.
FIGS. 7A to 7F are process diagrams illustrating another example of a producing method for a printing plate of an embodiment of the present invention.
FIGS. 8A to 8D are process diagrams illustrating an example of a producing method for a functional element of an embodiment of the present invention.
FIGS. 9A and 9B are process diagrams illustrating an example of a producing method for a functional element of an embodiment of the present invention.
FIGS. 10A and 10B are process diagrams illustrating another example of a producing method for a functional element of an embodiment of the present invention.
FIG. 11 is a schematic diagram illustrating an example of a printing apparatus of an embodiment of the present invention.

### Description of Embodiments

A printing plate, producing method for the printing plate, producing method for a functional element utilizing the printing plate and printing apparatus of the present disclosure are hereinafter described in detail.

### A. Printing plate

A printing plate for waterless planographic printing or intaglio printing of an embodiment of the present invention comprises a substrate containing an elastic body swellable in a solvent in an ink, a hydrophobic solvent permeation preventing layer that is a non-image portion formed on the substrate in a pattern and includes a function of inhibiting permeation of a solvent in an ink, and a hydrophilic portion that is an image portion formed on a surface of the substrate at an opening portion of the hydrophobic solvent permeation preventing layer and higher in hydrophilicity than the hydrophobic solvent permeation preventing layer.

The printing plate of an embodiment of the present invention is hereinafter described with reference to the drawings.

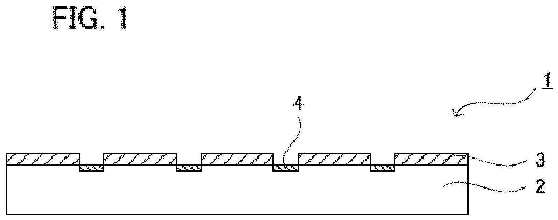

FIG. 1 is a schematic sectional view illustrating an example of a printing plate of an embodiment of the present invention, namely an example of a printing plate for planographic printing. As shown in FIG. 1, printing plate 1 comprises substrate 2 containing an elastic body swellable in a solvent in an ink, hydrophobic solvent permeation preventing layer 3 formed on substrate 2 in a pattern, and hydrophilic portion 4 that is formed on a surface of substrate 2 at an opening portion of hydrophobic solvent permeation preventing layer 3; and a surface of hydrophobic solvent permeation preventing layer 3 side of substrate 2 is flat.

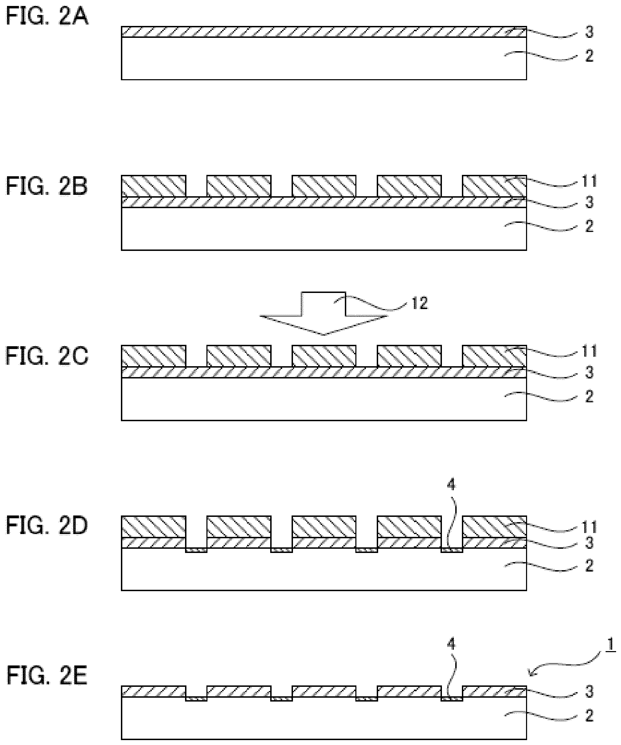

FIGS. 2A to 2E are process diagrams illustrating an example of a producing method for a printing plate of an embodiment of the present invention, namely an example of a producing method for a printing plate for planographic printing. First, as shown in FIG. 2A, hydrophobic solvent permeation preventing layer 3 is formed on substrate 2 containing an elastic body swellable in a solvent in an ink. Next, as shown in FIG. 2B, resist pattern 11 is formed on hydrophobic solvent permeation preventing layer 3; then as shown in FIG. 2C, oxidization treatment 12 such as plasma irradiation or vacuum ultraviolet irradiation is performed to the surface of hydrophobic solvent permeation preventing layer 3 by using resist pattern 11 as the mask. Thereby, as shown in FIG. 2D, hydrophobic solvent permeation preventing layer 3 at an opening portion of resist pattern 11 is removed, and the surface of substrate 2 at the opening portion of hydrophobic solvent permeation preventing layer 3 is hydrophilized. As the result, hydrophilic portion 4 is formed on the surface of substrate 2 at the opening portion of hydrophobic solvent permeation preventing layer 3. After that, resist pattern 11 is peeled off; then as shown in FIG. 2E, printing plate 1 is obtained.

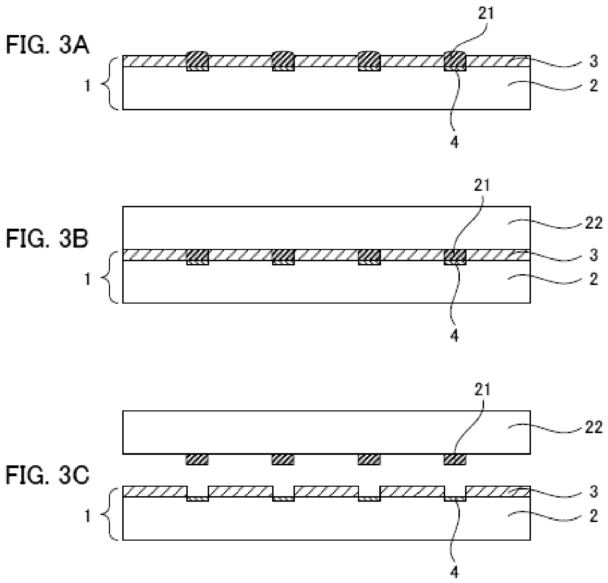

FIGS. 3A to 3C are process diagrams illustrating an example of a producing method for a print by using a printing plate of an embodiment of the present invention, namely an example using a printing plate for planographic printing. First, as exemplified in FIG. 3A, although not illustrated, printing plate 1 is coated with ink 21 by means of a coater head. Hydrophobic solvent permeation preventing layer 3 includes hydrophobicity and hydrophilic portion 4 is higher in hydrophilicity than hydrophobic solvent permeation preventing layer 3, so that ink 21 is adhered to only the surface of hydrophilic portion 4. Next, as exemplified in FIGS. 3B to 3C, substrate for printing 22 is adhered to the surface of printing plate 1 to which ink 21 is adhered; thereafter substrate for printing 22 is peeled off from printing plate 1 so as to transfer ink 21 to substrate for printing 22; thereby the intended pattern is printed.

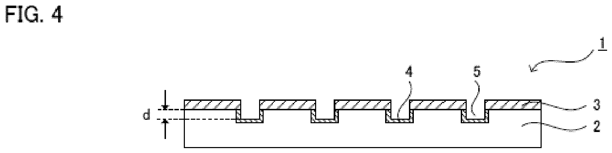

FIG. 4 is a schematic sectional view illustrating another example of a printing plate of an embodiment of the present invention, namely an example of a printing plate for intaglio printing. As exemplified in FIG. 4, printing plate 1 includes substrate 2 containing an elastic body swellable in a solvent in an ink, hydrophobic solvent permeation preventing layer 3 formed on substrate 2 in a pattern, and hydrophilic portion 4 formed on a surface of substrate 2 at an opening portion of hydrophobic solvent permeation preventing layer 3; and substrate 2 includes concave portion 5 on the surface at the opening portion of hydrophobic solvent permeation preventing layer 3.

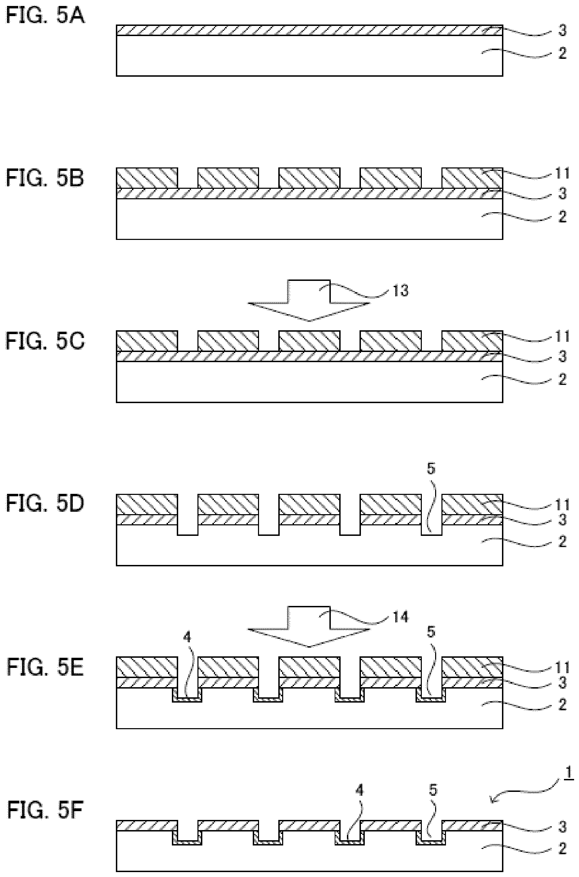

FIGS. 5A to 5F are process diagrams illustrating another example of a producing method for a printing plate of an embodiment of the present invention, namely an example of a producing method for a printing plate for intaglio printing. First, as shown in FIG. 5A, hydrophobic solvent permeation preventing layer 3 is formed on substrate 2. Next, as shown in FIG. 5B, resist pattern 11 is formed on hydrophobic solvent permeation preventing layer 3; then, as shown in FIG. 5C, physical treatment 13 such as plasma irradiation is performed to the surface of hydrophobic solvent permeation preventing layer 3 by using resist pattern 11 as the mask. Thereby, as shown in FIG. 5D, hydrophobic solvent permeation preventing layer 3 at an opening portion of resist pattern 11 is removed; further, the surface of substrate 2 at the opening portion of hydrophobic solvent permeation preventing layer 3 is removed, so as to form concave portion 5. Subsequently, as shown in FIG. 5E, hydrophilic treatment 14 such as plasma irradiation and vacuum ultraviolet irradiation is performed to the surface of substrate 2 by using resist pattern 11 as the mask. Thereby, the surface of substrate 2 at the opening portion of hydrophobic solvent permeation preventing layer 3 is hydrophilized; thus, hydrophilic portion 4 is formed on the surface of substrate 2 at the opening portion of hydrophobic solvent permeation preventing layer 3. After that, resist pattern 11 is peeled off; then as shown in FIG. 5F, printing plate 1 is obtained.

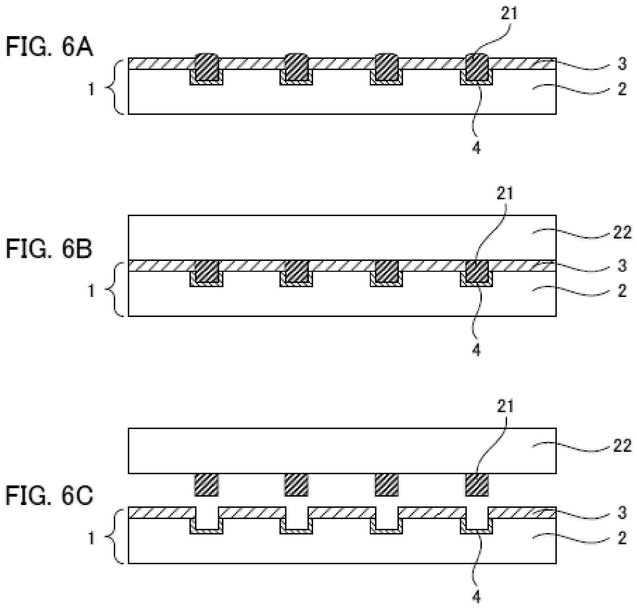

FIGS. 6A to 6C are process diagrams illustrating another example of a producing method for a print by using a printing plate of an embodiment of the present invention, namely an example using a printing plate for intaglio printing. First, as exemplified in FIG. 6A, although not illustrated, printing plate 1 is coated with ink 21 by means of a coater head. Hydrophobic solvent permeation preventing layer 3 includes hydrophobicity and hydrophilic portion 4 is higher in hydrophilicity than hydrophobic solvent permeation preventing layer 3, so that ink 21 is adhered to only hydrophilic portion 4 which is a concave portion. Next, as exemplified in FIGS. 6B to 6C, substrate for printing 22 is adhered to the surface of printing plate 1 to which ink 21 is adhered; thereafter substrate for printing 22 is peeled off from printing plate 1 so as to transfer ink 21 to substrate for printing 22; thereby the intended pattern is printed.

According to an embodiment of the present invention, the substrate contains an elastic body swellable in a solvent in an ink, so that the substrate may be swellable in a solvent in an ink. In the printing plate of an embodiment of the present invention, the hydrophilic portion is a portion such that the substrate surface is hydrophilized, and the substrate contains the elastic body swellable in a solvent, so that the solvent in the ink adhered to the hydrophilic portion of the printing plate may be permeated to the hydrophilic portion when printing by the printing plate of an embodiment of the present invention. Accordingly, the solvent in the ink is permeated to the hydrophilic portion of the printing plate from the time the ink is adhered to the hydrophilic portion of the printing plate to the time the ink is transferred to the substrate for printing, so that viscosity of the ink is gradually increased, together with evaporation of the solvent in the ink; thus agglutination force of the ink on the surface of the hydrophilic portion of the printing plate may be increased. Accordingly, complete transfer of the ink at the time of transferring the ink from the printing plate to the substrate for printing is possible, and transferability of the ink from the printing plate to the substrate for printing may be improved.

Also, in the printing plate of an embodiment of the present invention, the hydrophobic solvent permeation preventing layer includes a function of inhibiting permeation of a solvent. Accordingly, on the occasion of continuous printing using the printing plate of an embodiment of the present invention, the hydrophobic solvent permeation preventing layer is prevented from being swelled by the solvent in the ink, and the ink is prevented from being adhered to the surface of the hydrophobic permeation preventing layer. Thus, occurrence of base staining is inhibited and printing durability may be improved.

Also, on the occasion of producing the printing plate of an embodiment of the present invention, a hydrophilic portion may be formed in the manner such that a resist pattern is formed on the hydrophobic solvent permeation preventing layer, then the hydrophobic solvent permeation preventing layer is removed in a pattern by using the resist pattern, and thereafter the substrate surface is hydrophilized. In these manners, the resist pattern is formed on the hydrophobic solvent permeation preventing layer, so that the solvent in the resist may be prevented from permeating to the substrate. Accordingly, shape defect due to expansion of the resist pattern caused by leakage of the solvent in the resist permeated to the printing plate at the time of forming the resist may be prevented. Thus, the resist pattern with high resolution may be formed and a minute hydrophilic portion may be formed. Thereby, the usage of the printing plate of an embodiment of the present invention enables high-definition printing by utilizing the minute hydrophilic portion.

The printing plate of an embodiment of the present invention is hereinafter described in each constitution.

### 1. Hydrophobic solvent permeation preventing layer

The hydrophobic solvent permeation preventing layer in an embodiment of the present invention is formed on the substrate in a pattern and includes a function of inhibiting permeation of a solvent.

The hydrophobic solvent permeation preventing layer includes hydrophobicity. Here, "hydrophobicity" is referred to the case the contact angle to water of 25°C is 50° or more. In specific, the contact angle of the hydrophobic solvent permeation preventing layer to water of 25°C is 50° or more, preferably 70° or more, and more preferably 80° or more. If the contact angle of the hydrophobic solvent permeation preventing layer is in the range, difference of the contact angles between the hydrophobic solvent permeation preventing layer and hydrophilic portion may be increased, and thus high-definition printing by means of the printing plate of an embodiment of the present invention is possible.

Also, difference of the contact angles between the hydrophobic solvent permeation preventing layer and the hydrophilic portion is larger the better; specifically, preferably 10° or more; above all, preferably 40° or more, and particularly preferably 70° or more. Similarly to the above case, if difference of the contact angles between the hydrophobic solvent permeation preventing layer and hydrophilic portion is in the range, high-definition printing by means of the printing plate of an embodiment of the present invention is possible.

Incidentally, the contact angle may be measured by the manner such that 1 micro liter liquid is dropped on the layer to be measured, the liquid drop is observed by the side, and the angle between the liquid drop and the layer surface is measured. The contact angle may be measured by tools such as a contact angle measuring device manufactured by IMOTO MACHINERY CO. , LTD. or contact angle meter DM-901 manufactured by Kyowa Interface Science Co., Ltd.

The material to be used for the hydrophobic solvent permeation preventing layer may be the one including the hydrophobicity and a function of inhibiting permeation of a solvent, and capable of being removed by plasma irradiation and vacuum ultraviolet irradiation; example thereof may include polysiloxane and fluorinated polysiloxane including a two-dimensional crosslinking structure. As a commercial product for such material, a mold releasing agent used for a nanoimprint may be used.

Here, "two-dimensional crosslinking structure" refers to a polymer structure such that a polymer is crosslinked in the main chain direction . In an embodiment of the present invention, the hydrophobic solvent permeation preventing layer contains polysiloxane or fluorinated polysiloxane including the two-dimensional crosslinking structure, so as not to be swelled in a solvent.

Whether the polysiloxane or fluorinated polysiloxane includes the two-dimensional crosslinking structure or not may be judged by X-ray diffraction measurement for the thin film. In a three-dimensional crosslinking structure, a peak of higher-order structure that represents a network structure appears; however, peaks corresponding thereto do not appear in the two-dimensional crosslinking structure; thus, whether the structure is the two-dimensional crosslinking structure or the three-dimensional crosslinking structure may be confirmed thereby.

Also, the hydrophobic solvent permeation preventing layer may be such that the surface is subjected to a hydrophobic treatment. In specific, a metal layer with a hydrophobic layer formed on its surface may be used.

The hydrophobic layer includes the hydrophobicity, and is capable of being formed on the metal layer surface; example thereof may include a self-assembled monomolecular film using a compound that includes a hydrophobic group and a binding site bondable to the metal that constitutes the metal layer. Such self-assembled monomolecular film may stably form a chemical bond with the metal layer, so that adhesion of the hydrophobic layer with the metal layer may be improved. Thereby, on the occasion of transferring the ink by adhering the printing plate of an embodiment of the present invention to the substrate for printing, the hydrophobic layer is prevented from being peeled off, and printing durability of the printing plate may be improved.

The compound to be used for the self-assembled monomolecular film is not particularly limited if the compound includes a hydrophobic group and a binding site to the metal that constitutes the metal layer; examples thereof may include a thiol compound, disulfide compound, sulfide compound, silane coupling agent, and phosphoric acid compound. These compounds are appropriately selected in accordance with the factors such as the kind of the metal that constitutes the metal layer. For example, in the case of a thiol compound, a chemical bond may be formed by a reaction such as a gold-thiol reaction and silver-thiol reaction. Also, in the case of a phosphoric acid compound, a chemical bond may be formed favorably with titanium and aluminum, for example.

Also, these compounds preferably contain fluorine from the viewpoint of hydrophobicity. Above all, a thiol compound is preferably used. Examples of the thiol compound may include alkanethiol and fluorinated alkanethiol.

The metal material to be used for the metal layer may be the one that includes a function of inhibiting permeation of a solvent, and is bondable to a compound to be used for the self-assembled monomolecular film, and removable by plasma irradiation; examples thereof may include gold, silver, copper, platinum, palladium, chrome, molybdenum, tungsten, tantalum, nickel, aluminum, titanium, magnesium, calcium, lithium, and an alloy containing thereof. Also, indium tin oxide and indium zinc oxide may be used.

The hydrophobic solvent permeation preventing layer is a non-image portion; the pattern shape of the hydrophobic solvent permeation preventing layer is appropriately selected in accordance with factors such as the application of the printing plate and may be an arbitrary shape.

Also, the pattern size of the hydrophobic solvent permeation preventing layer is not particularly limited, but the hydrophilic portion that is an image portion in an embodiment of the present invention may be minute. In specific, the width of the opening portion of the hydrophobic solvent permeation preventing layer up to approximately 2 µm may be formed.

The thickness of the hydrophobic solvent permeation preventing layer is not particularly limited if the thickness allows the function of inhibiting permeation of a solvent to be exhibited and allows removal of the hydrophobic solvent permeation preventing layer by plasma irradiation and vacuum ultraviolet irradiation; the thickness is appropriately adjusted in accordance with the constitution of the hydrophobic solvent permeation preventing layer.

For example, if the hydrophobic solvent permeation preventing layer contains polysiloxane or fluorinated polysiloxane including the second-dimensional crosslinking structure, the thickness of the hydrophobic solvent permeation preventing layer is preferably in a range of about 2 nm to 50 nm, above all, preferably in a range of about 5 nm to 40 nm, and particularly preferably in a range of about 10 nm to 20 nm. If the thickness of the hydrophobic solvent permeation preventing layer is thin, intended hydrophobicity may not be obtained in some cases. Also, if the thickness of the hydrophobic solvent permeation preventing layer is thick, removal thereof by plasma irradiation and vacuum ultraviolet irradiation may be difficult in some cases.

Also, for example, if the hydrophobic solvent permeation preventing layer is a metal layer with a hydrophobic layer formed on its surface, the thickness of the hydrophobic layer is not particularly limited if the thickness allows the hydrophobicity to be sufficiently exhibited and allows formation of the self-assembled monomolecular film; the thickness is appropriately determined in accordance with factors such as the material for the hydrophobic layer. In specific, the thickness of the hydrophobic layer is preferably in a range of about 1 nm to 5 nm, and above all, preferably in a range of about 2 nm to 4 nm. If the thickness of the hydrophobic layer is in the range, intended hydrophobicity may be obtained, and also, the hydrophobic layer may be easily removed by plasma irradiation for example.

The thickness of the metal layer is not particularly limited if it allows the function of inhibiting permeation of a solvent to be exhibited; for example, the thickness is preferably in a range of about 10 nm to 300 nm, above all, preferably in a range of about 20 nm to 200 nm, and particularly preferably in a range of about 50 nm to 100 nm. If the thickness of the metal layer is in the range, the function of inhibiting permeation of a solvent may be exhibited, and also, the metal layer may be easily removed by plasma irradiation for example.

The forming method for the hydrophobic solvent permeation preventing layer is appropriately selected in accordance with factors such as the material. Incidentally, the forming method for the hydrophobic solvent permeation preventing layer is described in "B. Producing method for printing plate" later; thus the description herein is omitted.

### 2. Hydrophilic portion

The hydrophilic portion of an embodiment of the present invention is formed on the surface of the substrate at the opening portion of the hydrophobic solvent permeation preventing layer, and is higher in hydrophilicity than the hydrophobic solvent permeation preventing layer.

Hydrophilicity of the hydrophilic portion is higher than hydrophilicity of the hydrophobic solvent permeation preventing layer; specifically, the contact angle of water of 25°C is less than 50°. In more specific, the contact angle of the hydrophilic portion to water of 25°C is less than 50°, preferably 30° or less, and more preferably 20° or less. If the contact angle of the hydrophilic portion is in the range, difference of the contact angles between the hydrophilic portion and hydrophobic solvent permeation preventing layer may be increased, and thus high-definition printing by means of the printing plate of an embodiment of the present invention is possible.

Incidentally, the method for measuring the contact angle is as described above.

The hydrophilic portion is such that the substrate surface is hydrophilized. Incidentally, hydrophilization of the substrate surface is described in "B. Producing method for printing plate" later; thus the description herein is omitted.

The hydrophilic portion is an image portion; the pattern shape of the hydrophilic portion is appropriately selected in accordance with factors such as the application of the printing plate, and may be an arbitrary shape.

Also, the width of the hydrophilic portion is appropriately adjusted in accordance with factors such as application of the printing plate of an embodiment of the present invention. In an embodiment of the present invention, the hydrophilic portion maybe minute; specifically, the width of the hydrophilic portion up to approximately 2 µm may be formed.

### 3. Substrate

The substrate of an embodiment of the present invention contains an elastic body swellable in a solvent in an ink. The substrate containing an elastic body swellable in a solvent includes elasticity; thus, on the occasion of adhering the substrate for printing to the surface of the printing plate of the embodiment of the present invention so as to transfer the ink to the substrate for printing, pressure may be uniformly applied to the surface of the printing plate, and the adhesion of the printing plate with the substrate for printing may be increased. Thereby, transferability of the ink is improved to enable high-definition printing.

Examples of the elastic body swellable in a solvent may include an elastic body including a three-dimensional crosslinking structure.

Here, "three-dimensional crosslinking structure" refers to the state such that a network structure is formed by polymers that is three-dimensionally polymerized each other. The elastic body includes the three-dimensional crosslinking structure, so that the substrate may be swelled in a solvent.

Also, the rubber hardness of the elastic body swellable in a solvent is preferably in a range of about 60° to 90°, and above all, preferably in a range of about 70° to 80°. If the rubber hardness of the elastic body is too low, it is too soft and thus the size and position of the pattern may be inaccurate at the time of printing in some cases. Also, if the rubber hardness of the elastic body is too high, it is afraid that removing the ink from the printing plate at the time of cleaning may be difficult.

Incidentally, the rubber hardness is the value measured by a method based on JIS K6253 and using an Asker rubber hardness meter A type (type A, durometer).

Examples of such elastic body swellable in a solvent may include silicone rubber, acrylic rubber, urethanerubber, fluoro rubber, polysulfide rubber, ethylene-propylene rubber, nitrile rubber, butyl rubber, chloroprene rubber, butadiene rubber, and styrene-butadiene rubber. Above all, silicone rubber, acrylic rubber, and urethane rubber are preferable; particularly silicone rubber is preferable. The reason therefor is because these are easily swelled in a solvent included in the later-described ink. Also, in the case of silicone rubber, the complete transfer is easily attained and transferability may be further improved.

Examples of the material for silicone rubber to be used for the substrate may include polydimethylsiloxane and the copolymer thereof, polydimethylsiloxane containing a fluorine group and the copolymer thereof, polyvinylmethylsiloxane, and polyphenylmethylsiloxane.

Also, examples of the material for acrylic rubber to be used for the substrate may include ethyl polyacrylate, butyl polyacrylate, and methoxyethyl polyacrylate.

The substrate may be a single layer that contains the elastic body swellable in a solvent, and may be the one with an elastic body layer that contains the elastic body swellable in a solvent and is formed on a supporting body. Examples of the supporting body may include a glass substrate, resin substrate, ceramic substrate, and metal substrate.

Also, as exemplified in FIG. 1, the surface of hydrophobic solvent permeation preventing layer 3 side of substrate 2 may be flat; and as exemplified in FIG. 4, the surface of substrate 2 may include concave portion 5 at the opening portion of hydrophobic solvent permeation preventing layer 3.

Here, the surface of the hydrophobic solvent permeation preventing layer side of the substrate being flat means that the surface of the substrate does not include a concave portion at the opening portion of the hydrophobic solvent permeation preventing layer; it means that a portion of the substrate in which the hydrophobic solvent permeation preventing layer is formed and a portion of the substrate in which the hydrophobic solvent permeation preventing layer is not formed are flat as the whole. If the printing plate is in a roll shape, the surface of the hydrophobic solvent permeation preventing layer side of the substrate may be a flat curved surface.

Also, the surface of the substrate including a concave portion at the opening portion of the hydrophobic solvent permeation preventing layer means that the end portion of the concave portion of the substrate matches the end portion of the opening portion of the hydrophobic solvent permeation preventing layer. In FIG. 4 for example, the end portion of concave portion 5 of substrate 2 matches the end portion of the opening portion of hydrophobic solvent permeation preventing layer 3.

As exemplified in FIG. 1, if the level difference between hydrophobic solvent permeation preventing layer 3 and hydrophilic portion 4 is small, the printing plate may be a printing plate for planographic printing; as exemplified in FIG. 4, if the level difference between hydrophobic solvent permeation preventing layer 3 and hydrophilic portion 4 is large, the printing plate may be a printing plate for intaglio printing.

When the printing plate is a printing plate for intaglio printing, the depth of the concave portion is not particularly limited if the depth is to the extent that can be formed by plasma irradiation for example, but is specifically preferably in a range of about 0.2 µm to 500 µm. If the depth of the concave portion is small, the ink adhered to the concave portion may not be maintained in some cases. Also, if the depth of the concave portion is large, it is difficult to form the concave portion.

Here, the depth of the concave portion refers to the depth from the substrate surface in the region the hydrophobic solvent permeation preventing layer is formed to the substrate surface in the region the hydrophobic solvent permeation preventing layer is not formed. As shown in FIG. 4 for example, the depth of concave portion 5 is represented by "d".

On the other hand, even when the surface of the substrate includes the concave portion at the opening portion of the hydrophobic solvent permeation preventing layer, if the depth of the concave portion is small and the level difference between the hydrophobic solvent permeation preventing layer and the hydrophilic portion is small, the printing plate may be a printing plate for planographic printing. When the printing plate is a printing plate for planographic printing, the depth of the concave portion is specifically preferably 200 nm or less.

### 4. Printing plate

The shape of the printing plate of an embodiment of the present invention may be a plate shape as exemplified in FIG. 1, and may be in a roll shape although not illustrated.

### 5. Application

The printing plate of an embodiment of the present invention may be applied such as to: form an electrode, semiconductor layer, gate insulating layer and interlayer insulating layer in a semiconductor element such as a transistor and diode, form a pixel electrode in a TFT substrate, form a rear electrode in a solar cell, form a rear electrode in an organic EL element, form an electrode and polymer layer of a nonvolatile memory, form an electrode and polymer layer of a pressure sensor, form a wiring in a wiring substrate, form a color layer and light-shielding portion in a color filter, and produce a biochip. In particular, the printing plate of an embodiment of the present invention may be used favorably to produce an electronic device that requires minute patterns.

In an embodiment of the present invention, as exemplified in FIGS. 3A to 3C, ink 21 is adhered to hydrophilic portion 4 of printing plate 1, and thus ink 21 is transferred to substrate for printing 22. As the solvent to be included in the ink, the one permeable to the substrate but not permeated to the hydrophobic solvent permeation preventing layer, namely the one that swell the substrate but does not swell the hydrophobic solvent permeation preventing layer is used. Such solvent is appropriately selected in accordance with factors such as the material for the substrate and hydrophobic solvent permeation preventing layer. Specific examples thereof may include toluene, xylene, mesitylene, methanol, ethanol, 2-propanol, butanol, 1-methoxy2-propanol, terpineol, propyleneglycol1-monomethylether2-acetate, acetone, methyl ethyl ketone, and methyl isobutyl ketone.

### B. Producing method for printing plate

The producing method for the printing plate for waterless planographic printing or intaglio printing of an embodiment of the present invention comprises a hydrophobic solvent permeation preventing layer forming step of forming a hydrophobic solvent permeation preventing layer including a function of inhibiting permeation of a solvent in an ink on a substrate containing an elastic body swellable in a solvent in an ink; a resist pattern forming step of forming a resist pattern on the hydrophobic solvent permeation preventing layer; a removing and hydrophilizing step of removing the hydrophobic solvent permeation preventing layer at an opening portion of the resist pattern, and hydrophilizing the exposed substrate surface to form a hydrophilic portion; and a resist pattern peeling step of peeling the resist pattern; wherein the method allows a printing plate with the hydrophilic portion as an image portion and the hydrophobic solvent permeation preventing layer as a non-image portion to be obtained.

FIGS. 2A to 2E are process diagrams illustrating an example of a producing method for a printing plate of an embodiment of the present invention, namely an example of a producing method for a printing plate for planographic printing. Incidentally, FIGS. 2A to 2E are described in "A. Printing plate" above; thus the description herein is omitted.

In this case, a resist pattern is formed on the hydrophobic solvent permeation preventing layer, and then oxidization treatment such as plasma irradiation and vacuum ultraviolet irradiation is performed, so that the hydrophobic solvent permeation preventing layer is removed in a pattern and the substrate surface is hydrophilized to form a hydrophilic portion. Thereby, a printing plate with the hydrophilic portion as the image portion and the hydrophobic solvent permeation preventing layer surface as the non-image portion may be obtained.

FIGS. 5A to 5F are process diagrams illustrating another example of a producing method for a printing plate of an embodiment of the present invention, namely an example of a producing method for a printing plate for intaglio printing. Incidentally, FIGS. 5A to 5F are described in "A. Printing plate" above; thus the description herein is omitted.

In this case, a resist pattern is formed on the hydrophobic solvent permeation preventing layer, and then physical treatment such as plasma irradiation is performed, so that the hydrophobic solvent permeation preventing layer is removed in a pattern and the substrate surface is removed in a pattern; thereafter hydrophilic treatment such as plasma irradiation and vacuum ultraviolet irradiation is performed so that the substrate surface is hydrophilized to form a hydrophilic portion. Thereby, a printing plate with the hydrophilic portion as the image portion and the hydrophobic solvent permeation preventing layer as the non-image portion may be obtained.

In an embodiment of the present invention, the hydrophobic solvent permeation preventing layer has the function of inhibiting permeation of a solvent; thus, the solvent in the resist is inhibited from permeating to the substrate by forming the resist pattern on the hydrophobic solvent permeation preventing layer. Thereby, the shape defect of the resist pattern due to expansion caused by leakage of the solvent in the resist permeated to the printing plate at the time of forming the resist pattern to the resist pattern may be inhibited. Accordingly, the resist pattern may be formed with high resolution, and a minute hydrophilic portion maybe formed. Thus, a printing plate that enables high-definition printing by utilizing the minute hydrophilic portion may be obtained.

Also, according to the embodiment of the present invention, the substrate containing an elastic body swellable in a solvent is used, so that the substrate may be swelled in a solvent. In the producing method for the printing plate of the embodiment of the present invention, the substrate surface is hydrophilized so as to form the hydrophilic portion, and the substrate contains the elastic body swellable in a solvent; thus, on the occasion of printing by the printing plate to be produced by the embodiment of the present invention, the solvent in the ink adhered to the hydrophilic portion of the printing plate may be permeated to the hydrophilic portion, viscosity of the ink may be increased, and agglutination of the ink may be improved. Thereby, the printing plate with excellent transferability of the ink from the printing plate to the substrate for printing may be obtained.

Also, on the occasion of repeatedly printing by the printing plate to be produced by the embodiment of the present invention, the hydrophobic solvent permeation preventing layer includes the function of inhibiting permeation of a solvent, so that the hydrophobic solvent permeation preventing layer is inhibited from being swelled by the solvent in the ink; thus, the ink is prevented from being adhered to the surface of the hydrophobic solvent permeation preventing layer. Thereby, the base staining is inhibited and the printing plate with excellent printing durability may be obtained.

Also, according to an embodiment of the present invention, by appropriately selecting the conditions for removing and hydrophilizing step, it is possible to adjust the level difference between the hydrophobic solvent permeation preventing layer and the hydrophilic portion, which is the depth of the grave to be formed with the hydrophobic solvent permeation preventing layer and the hydrophilic portion. Accordingly, it is possible to produce printing plates from the one for planographic printing in which the grave depth is nanometer order and almost flat to the one for intaglio printing in which the grave depth is micrometer order. In the printing plate for intaglio printing, the thickness of the ink to be transferred to the substrate for printing may be positively controlled since the ink amount to be filled may be adjusted in accordance with the grave depth.

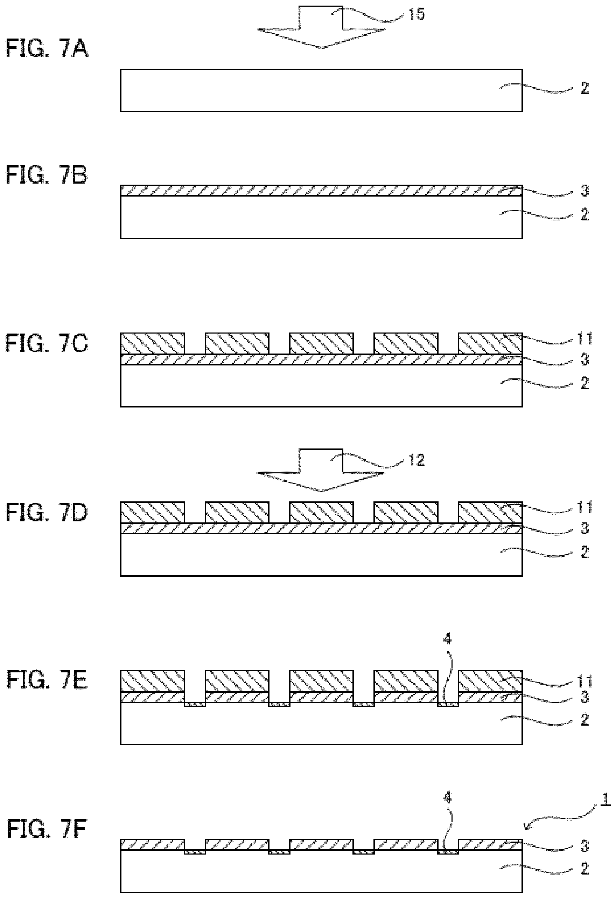

FIGS. 7A to 7F are process diagrams illustrating another example of a producing method for a printing plate of an embodiment of the present invention. First, as shown in FIG. 7A, a pre-treating step of hydrophilizing the surface of substrate 2 is performed by hydrophilic treatment 15 such as plasma irradiation and vacuum ultraviolet irradiation. Next, as shown in FIG. 7B, the surface-hydrophilized substrate 2 is coated with a coating solution for forming hydrophobic solvent permeation preventing layer so as to form hydrophobic solvent permeation preventing layer 3. Incidentally, FIGS. 7C to 7F are the same as FIGS. 2B to 2E; thus omitted.

In these manners, in an embodiment of the present invention, the pre-treating step is preferably performed before the hydrophobic solvent permeation preventing layer forming step. In this case, adhesion of the substrate to the hydrophobic solvent permeation preventing layer may be improved. Thereby, on the occasion of transferring the ink by adhering the printing plate to be produced by the embodiment of the present invention to the substrate for printing, the hydrophobic solvent permeation preventing layer may be prevented from peeling off from the substrate; thus, the printing plate with high printing durability may be obtained.

The producing method for the printing plate of an embodiment of the present invention is hereinafter described in each step.

### 1. Hydrophobic solvent permeation preventing layer forming step

A hydrophobic solvent permeation preventing layer forming step in an embodiment of the present invention is a step of forming a hydrophobic solvent permeation preventing layer on a substrate containing an elastic body swellable in a solvent.

The forming method for the hydrophobic solvent permeation preventing layer is appropriately selected in accordance with factors such as the material.

For example, for the case of forming the hydrophobic solvent permeation preventing layer that contains polysiloxane and fluorinated polysiloxane including the second-dimensional crosslinking structure, an example of the method may be such that a substrate is coated with a coating solution for forming hydrophobic solvent permeation preventing layer that contains polysiloxane and fluorinated polysiloxane including the second-dimensional structure. The coating method is not particularly limited if the entire surface of the substrate may be coated with the coating solution for forming hydrophobic solvent permeation preventing layer thereby; for example, general methods such as a spin coat method, die coat method, roll coat method, bar coat method, dip coat method, spray coat method, blade coat method, gravure printing method, slit coat method, ink-jet method, and flexo printing method may be used.

In addition, for example, for the case of forming the metal layer with a hydrophobic layer formed on its surface as the hydrophobic solvent permeation preventing layer, examples of the forming method for the metal layer may include a vacuum vapor deposition method, sputtering method, and a method by coating a layer with the metal-particles-dispersed ink and burning thereof. Also, the forming method for the hydrophobic layer may be the method capable of forming the self-assembled monomolecular film; examples thereof may include a dip method, spray method, die coat method, spin coat method, and vapor deposition method.

Incidentally, other points of the hydrophobic solvent permeation preventing layer and the substrate are described in details in "A. Printing plate" above; thus, the descriptions herein are omitted.

### 2. Resist pattern forming step

A resist pattern forming step in an embodiment of the present invention is a step of forming a resist pattern on the hydrophobic solvent permeation preventing layer.

Examples of the forming method for the resist pattern may include a method such that the hydrophobic solvent permeation preventing layer is coated with a photoresist and exposed to light so as to develop the pattern, and a method of directly forming the resist pattern by methods such as a screen printing method.

The resist to be used for forming the resist pattern may be the one formable on the hydrophobic solvent permeation preventing layer, and appropriately selected from general resists and used. Also, as the photoresist, both the positive type and negative type may be used.

Above all, the resist preferably contains a surfactant including a fluorine group. The reason therefor is because such resist may effectively decrease the surface tension of the resist, so that the hydrophobic solvent permeation preventing layer may be favorably coated with the resist even if the surface of the hydrophobic solvent permeation preventing layer is high in hydrophobicity. The surfactant including a fluorine group is not particularly limited if it is soluble to the resist; both the polymer system and low molecular system may be used and a general fluorine-based surfactant may be used.

Also, the solvent to be included in the resist and used is the one that neither dissolves the hydrophobic solvent permeation preventing layer nor permeated to the hydrophobic solvent permeation preventing layer, which is the one neither dissolves the hydrophobic solvent permeation preventing layer nor swell the hydrophobic solvent permeation preventing layer. Such solvent is appropriately selected in accordance with factors such as the material for the hydrophobic solvent permeation preventing layer; examples thereof may include propylene glycol monomethyl ether acetate, methyl ethyl ketone, 2-heptanon, cyclohexanone, cyclopentanone, toluene, xylene, mesitylene, acetone, methanol, ethanol, and isopropanol.

The thickness of the resist pattern may be the thickness capable of protecting the hydrophobic solvent permeation preventing layer disposed beneath the resist pattern during the later-described removing and hydrophilizing step, and appropriately adjusted.

### 3. Removing and hydrophilizing step

A removing and hydrophilizing step in an embodiment of the present invention is a step of removing the hydrophobic solvent permeation preventing layer at the opening portion of the resist pattern, and hydrophilizing the exposed substrate surface.

The removing and hydrophilizing step may be such that the hydrophobic solvent permeation preventing layer at the opening portion of the resist pattern is removed and the exposed substrate surface is hydrophilized by a single treatment; also, the step may be such that a step of removing the hydrophobic solvent permeation preventing layer at the opening portion of the resist pattern and a step of hydrophilizing the exposed substrate surface are performed separately.

When producing a printing plate for planographic printing, in the removing and hydrophilizing step, removing the hydrophobic solvent permeation preventing layer at the opening portion of the resist pattern and hydrophilizing the exposed substrate surface may be performed by a single treatment, and the step of removing the hydrophobic solvent permeation preventing layer at the opening portion of the resist pattern and the step of hydrophilizing the exposed substrate surface may be performed separately. Above all, removing the hydrophobic solvent permeation preventing layer at the opening portion of the resist pattern and hydrophilizing the exposed substrate surface by a single treatment is preferable.

On the other hand, when producing a printing plate for intaglio printing, the removing and hydrophilizing step preferably comprises a removing step of removing the hydrophobic solvent permeation preventing layer at the opening portion of the resist pattern and further removing the exposed substrate surface so as to form a concave portion on the substrate surface, and a hydrophilizing step of hydrophilizing the exposed substrate surface.

When removing the hydrophobic solvent permeation preventing layer at the opening portion of the resist pattern and hydrophilizing the exposed substrate surface by a single treatment, the treatment is not particularly limited if it allows the hydrophobic solvent permeation preventing layer at the opening portion of the resist pattern to be removed and allows the exposed substrate surface to be hydrophilized; the treatment is appropriately selected in accordance with factors such as the material for the hydrophobic solvent permeation preventing layer. Examples thereof may include an oxidization treatment such as plasma irradiation, vacuum ultraviolet irradiation, and UV-ozone treatment. If the hydrophobic solvent permeation preventing layer is the metal layer with the hydrophobic layer formed on its surface, plasma irradiation is preferable.

By plasma irradiation, plasma of a reactive gas is generated and irradiated. Examples of the reactive gas may include oxygen. Also, the reactive gas may include nitrogen, argon, and helium for example. Also, in plasma irradiation, for example, plasma may be irradiated under decompressed state, and plasma may be irradiated under atmospheric pressure. Atmospheric pressure plasma is advantageous in view of cost and production efficiency for example.

Also, by irradiating vacuum ultraviolet light, the hydrophobic solvent permeation preventing layer at the opening portion of the resist pattern may be removed and the exposed substrate surface may be hydrophilized.

Here, "vacuum ultraviolet light" signifies the ultraviolet with the wave length in a range of about 10 nm to 200 nm. The vacuum ultraviolet light is not particularly limited if it includes the wavelength capable of removing the hydrophobic solvent permeation preventing layer; vacuum ultraviolet light with appropriate wavelength in accordance with factors such as the material for the hydrophobic solvent permeation preventing layer may be used. Above all, the wavelength of the vacuum ultraviolet light is preferably in a range of about 126 nm to 193 nm, and more preferably 172 nm.

Examples of the light source to be used for the irradiating vacuum ultraviolet light may include an excimer lamp and low pressure mercury lamp. Also, the irradiation amount of the vacuum ultraviolet light may be to the extent that may remove the hydrophobic solvent permeation preventing layer and hydrophilize the substrate surface, and is appropriately adjusted in accordance with factors such as the material for the hydrophobic solvent permeation preventing layer and the wavelength of the vacuum ultraviolet light.

Also, in the UV-ozone treatment, oxygen and air that generate ozone may be used.

Also, if the removing and hydrophilizing step comprises a removing step of removing the hydrophobic solvent permeation preventing layer at the opening portion of the resist pattern and further removing the exposed substrate surface so as to form a concave portion on the substrate surface, and a hydrophilizing step of hydrophilizing the exposed substrate surface, the method for removing the hydrophobic solvent permeation preventing layer in the removing step is not particularly limited if the method allows the hydrophobic solvent permeation preventing layer at the opening portion of the resist pattern to be removed, and allows the exposed substrate surface to be removed so as to form a concave portion, and is appropriately selected in accordance with factors such as the material for the hydrophobic solvent permeation preventing layer. Examples thereof may include a physical treatment such as dry etching and cutting by tools. Above all, dry etching is preferable since minute processing is possible therewith.

Examples of the dry etching may include plasma irradiation .

Examples of the reactive gas that generates plasma may include a mixed gas of oxygen and CF₄, and a mixed gas of oxygen and C₄F₈. Also, the reactive gas may include nitrogen, argon, and helium for example. Also, in plasma irradiation, the plasma may be irradiated in decompressed state, and the plasma may be irradiated under atmospheric pressure.

Also, the method for hydrophilizing the substrate surface in the hydrophilizing step is not particularly limited if it gives hydrophilicity to the substrate surface; examples thereof may include a hydrophilic treatment such as plasma irradiation, vacuum ultraviolet irradiation, and UV-ozone treatment.

The plasma irradiation, vacuum ultraviolet irradiation, and UV-ozone treatment may be the same as in the case of the single treatment.

Also, the removing and hydrophilizing step is preferably performed so as to hydrophilize the hydrophilic portion to be formed on the substrate surface with the intended hydrophilicity.

Incidentally, the hydrophilic portion is described in details in "A. Printing plate" above; thus, the description herein is omitted.

### 4. Resist pattern peeling step

A resist pattern peeling step in an embodiment of the present invention is a step of peeling the resist pattern.

The method for peeling the resist pattern is not particularly limited if the method affects neither hydrophobicity of the hydrophobic solvent permeation preventing layer nor hydrophilicity of the hydrophilic portion; a general method for peeling a resist may be used, and both the wet process and dry process may be applied.

### 5. Pre-treating step

In an embodiment of the present invention, a pre-treating step of hydrophilizing the substrate surface is preferably performed before the hydrophobic solvent permeation preventing layer forming step.

The hydrophilic treatment is not particularly limited if it gives hydrophilicity to the substrate surface; examples thereof may include a UV-ozone treatment, vacuum ultraviolet irradiation, and plasma irradiation.

In a UV-ozone treatment, oxygen and air that generates ozone may be used.

In plasma irradiation, examples of the reactive gas that generates plasma may include oxygen, nitrogen, argon, andhelium. Also, in plasma irradiation, for example, plasma may be irradiated in decompressed state, and plasma may be irradiated under atmospheric pressure.

### 6. Printing plate

The shape of the printing plate to be produced by an embodiment of the present invention may be a plate shape as exemplified in FIG. 1, and may be in a roll shape although not illustrated.

If the roll shape printing plate is to be produced, the roll shape printing plate may be produced by winding a plate shape printing plate to be a roll shape; also, the roll shape printing plate may be produced by conducting the each step by using a cylindrical substrate.

### C. Producing method for functional element

A producing method for a functional element of an embodiment of the present invention comprises a printing plate preparing step of preparing a printing plate for waterless planographic printing comprising: a substrate containing an elastic body swellable in a solvent in a ink, a hydrophobic solvent permeation preventing layer that is a non-image portion formed on the substrate in a pattern and includes a function of inhibiting permeation of a solvent in an ink, and a hydrophilic portion that is an image portion formed on a surface of the substrate at an opening portion of the hydrophobic solvent permeation preventing layer and higher in hydrophilicity than the hydrophobic solvent permeation preventing layer, wherein a surface of the hydrophobic solvent permeation preventing layer side of the substrate is flat; a blanket preparing step of preparing a blanket including a second substrate that contains an elastic body swellable in a solvent and includes a hydrophilic region on the surface; a coating step of coating the hydrophilic region side surface of the blanket with a coating solution for forming functional layer; a first transferring step of transferring the coating solution for forming functional layer in the blanket to only the hydrophilic portion of the printing plate by making the blanket to contact with the printing plate via the coating solution for forming functional layer; and a second transferring step of forming a functional layer by transferring the coating solution for forming functional layer remaining in the blanket to a substrate for forming functional layer, wherein the hydrophilic region of the blanket is higher in hydrophilicity than the hydrophobic solvent permeation preventing layer of the printing plate, and is equal to or lower in hydrophilicity than the hydrophilic portion of the printing plate.

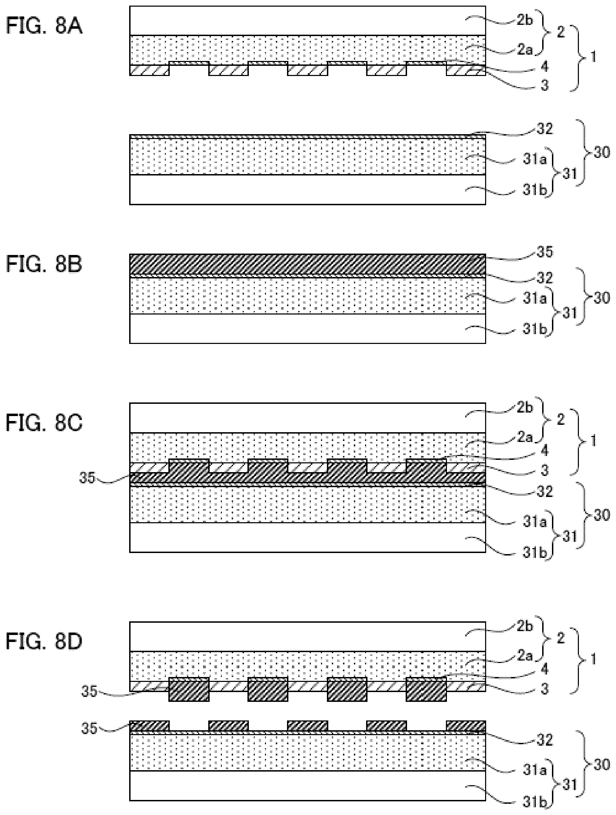

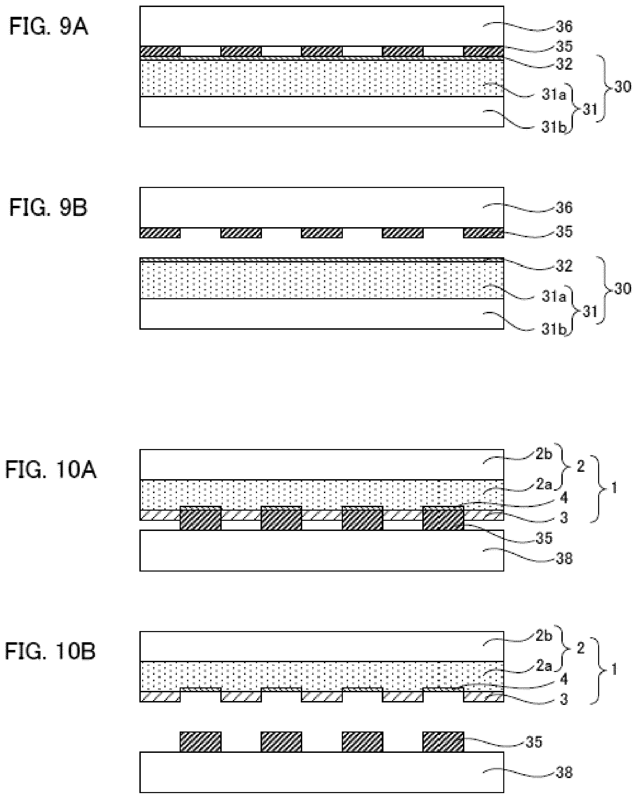

FIGS. 8A to 8D and FIGS. 9A to 9B are process diagrams illustrating an example of a producing method for a functional element of an embodiment of the present invention. First to be conducted is, as exemplified in FIG. 8A, a printing plate preparing step of preparing printing plate 1 comprising: substrate 2 in which elastic body layer 2a is formed on supporting body 2b, hydrophobic solvent permeation preventing layer 3 formed on substrate 2 in a pattern, and hydrophilic portion 4 that is formed on a surface of substrate 2 at an opening portion of hydrophobic solvent permeation preventing layer 3 and higher in hydrophilicity than hydrophobic solvent permeation preventing layer 3, wherein a surface of hydrophobic solvent permeation preventing layer 3 side of substrate 2 is flat. Also to be conducted is a blanket preparing step of preparing blanket 30 including second substrate 31 in which elastic body layer 32a is formed on supporting body 31b and a surface of elastic body layer 32a includes hydrophilic region 32. Hydrophilic region 32 of blanket 30 is higher in hydrophilicity than hydrophobic solvent permeation preventing layer 3 of printing plate 1, and equal to or lower in hydrophilicity than hydrophilic portion 4. Next to be conducted is, as exemplified in FIG. 8B, a coating step of coating the entire surface of hydrophilic region 32 of blanket 30 with coating solution for forming functional layer 35. Next to be conducted is, as exemplified in FIGS. 8C to 8D, a first transferring step of transferring coating solution for forming functional layer 35 in blanket 30 to only hydrophilic portion 4 of printing plate 1 by making blanket 30 to contact with printing plate 1 via coating solution for forming functional layer 35. Next to be conducted is, as exemplified in FIGS. 9A to 9B, a second transferring step of forming a functional layer by transferring coating solution for forming functional layer 35 remaining in blanket 30 to substrate for forming functional layer 36.

Here, in adhesion science, a theory of Weak Boundary Layer has been known. Incidentally, Weak Boundary Layer may be hereinafter referred as WBL in some cases. The theory of WBL is such that adhesion is always destructed in a weak layer which is present in the vicinity of the interface between any adhered phases, and thus the pure interface destruction is impossible. Also, WBL is presumed to be formed by the manner that a low molecular component and additive are segregated on the surface.

In an embodiment of the present invention, it is considered that WBL is formed in the interface between the hydrophilic region of the blanket and the coating solution for forming functional layer at the time of coating the surface of the hydrophilic region side of the blanket with the coating solution for forming functional layer.

In an embodiment of the present invention, the hydrophilic region of the blanket is higher in hydrophilicity than the hydrophobic solvent permeation preventing layer of the printing plate and equal to or lower in hydrophilicity than the hydrophilic portion of the printing plate. Accordingly, when the hydrophilic region of the blanket is higher in hydrophilicity than the hydrophobic solvent permeation preventing layer of the printing plate and lower in hydrophilicity than the hydrophilic portion of the printing plate, the coating solution for forming functional layer may be transferred only to the hydrophilic portion of the printing plate by means of the difference in hydrophilicity and WBL in the first transferring step. Also, when the hydrophilic region of the blanket is higher in hydrophilicity than the hydrophobic solvent permeation preventing layer of the printing plate and equal in the hydrophilicity to the hydrophilic portion of the printing plate, the coating solution for forming functional layer may be transferred to only the hydrophilic portion of the printing plate by means of WBL in the first transferring step.

Also, in general, from the viewpoint of transferability, the substrate for forming functional layer is set higher in hydrophilicity than the hydrophilic region of the blanket. If the substrate for forming functional layer is higher in hydrophilicity than the hydrophilic region of the blanket, the coating solution for forming functional layer maybe transferred to the substrate for forming functional layer by means of the difference in hydrophilicity and WBL in the second transferring step. Also, if the substrate for forming functional layer is equal in hydrophilicity to the hydrophilic region of the blanket, the coating solution for forming functional layer may be transferred to the substrate for forming functional layer by means of WBL in the second transferring step.

In these manners, in the embodiment of the present invention, the coating solution for forming functional layer may be transferred not only by means of the difference in hydrophilicity, but also WBL; thus, transferability may be improved.

Conventionally, peeling offset printing, reversing offset printing, and micro-contact offset printing have been known as technologies that enable minute printing in micrometer order, for example.

In peeling offset printing, the entire surface of a waterless flat plate is uniformly coated with ink, the ink on a silicone rubber layer in the waterless flat plate is transferred to ablanket, and the ink transferred to the blanket is transferred to a substrate for printing. Silicone rubber is mainly used for the blanket and the silicone rubber layer of the waterless flat plate is a hydrophobic non-image portion; thus, the blanket and the silicone rubber layer of the waterless flat plate are considered to be equal in wettability. Accordingly, the ink is transferred from the silicone rubber layer of the waterless flat plate to the blanket greatly by means of WBL formed at the interface between the silicone rubber layer of the waterless flat plate and the ink. Also, the ink transfer from the blanket to the substrate for printing is mainly caused by the difference in wettability between the blanket and the substrate for printing.

In contrast, the embodiment of the present invention allows the coating solution for forming functional layer to be transferred by means of not only the difference in wettability but also by means of WBL in both the first transferring step and the second transferring step; thus, transferability may be improved.

Also, in reversing offset printing, ink uniformly coated on the surface of the blanket is transferred to a convex plate and the ink remaining in the blanket is transferred to the substrate for printing. In reversing offset printing, the concave and convex of the convex plate form an image, but certain depth of the grave in the convex plate is necessary to make an effective plate for printing. The grave of the convex plate is formed by etching and photolithography; however, the aspect ratio in the depth direction is always present; thus, to ensure the grave depth, the resolution has to be deteriorated.

In contrast, in the embodiment of the present invention, the hydrophilic portion and the hydrophobic solvent permeation layer of the printing plate differ in hydrophilicity form an image. The printing plate includes graves of from a few nanometer to hundreds nanometer in accordance with the level difference between the hydrophobic solvent permeation preventing layer and the hydrophilic portion; however, in a general printing method, even in the case of minute concave and convex, the amount to be pushed in is controlled in micron order; thus, the printing plate with the above-described grave is substantially handled as a flat surface. Also, the hydrophilic portion is a portion that the substrate surface is hydrophilized; thus, the aspect ratio in the depth direction is not present in a hydrophilic treatment such as vacuum ultraviolet irradiation, plasma irradiation, and UV-ozone treatment. Accordingly, the embodiment of the present invention allows a printing plate to be excellent in resolution; thereby, high resolution printing is possible by the printing plate.

Also, in micro-contact printing, the entire surface of a concave and convex plate is coated with ink and the concave and convex plate is adhered to a substrate for printing so as to transfer the ink from only the convex portion of the concave and convex plate to a substrate for printing.

Reversing offset printing is a method that uses a convex plate including concaves and convexes in micrometer order; if the pressure for transferring ink from a blanket to the convex plate is too much, the ink is transferred to not only the convex portion in the convex plate but also to the concave portion. Also, a micro-contact printing is a method that uses a concave and convex plate including concaves and convexes in micrometer order; if the pressure for transferring the ink from the concave and convex plate to a substrate for printing is too much, not only the ink on the convex portion in the concave and convex plate but also the ink in the concave portion is transferred to the substrate for printing. Such phenomenon is called "bottom contact" and printing defect is caused by this bottom contact. To transfer the ink from the blanket to only the convex portion of the convex plate or to transfer only the ink on the convex portion in the concave and convex plate to the substrate for printing without causing the bottom contact, it is necessary to control the pressure for the transfer.

In contrast, in the embodiment of the present invention, the coating solution for forming functional layer is transferred by means of the difference in hydrophilicity among the hydrophilic region of the blanket, the hydrophobic solvent permeation preventing layer of the printing plate, and the hydrophilic portion of the printing plate as well as WBL, so that printing defect caused by the bottom contact maybe inhibited. Accordingly, an acceptable range for the pressure in the first transferring step may be widened, thus printing is possible even when the pressure is comparatively large.

FIGS. 8A to 8D, FIGS. 9A to 9B, and FIGS. 10A to 10B are process diagrams illustrating another example of a producing method for a functional element of an embodiment of the present invention. Incidentally, FIGS. 8A to 8B and FIGS. 9A to 9B are described above; thus the description herein is omitted. Next to be conducted is, as exemplified in FIGS. 10A to 10B, a removing step of transferring coating solution for forming functional layer 35 transferred to hydrophilic portion 4 of printing plate 1, to substrate for cleaning 38.

In a conventional reversing offset printing, to continuously perform the printing operation, it is necessary that the blanket and the convex plate are in clean condition after each printing. The reason therefor is because accumulation of the remaining ink in the blanket and convex plate may lead to the pattern defect. In the reversing offset printing, the surface of the blanket is reset by completely transferring the ink from the surface of the blanket to the substrate for printing. Meanwhile, the ink received on the convex plate is not removed, and thus an additional cleaning step is necessary. Suggested cleaning methods for a convex plate may include a method to wipe off the ink by a solvent; a method such that a solvent is dispersed to dissolve the ink, the ink adhered to the convex portion of the convex plate is directly scraped up by a doctor blade, and thereafter the ink solution remaining in the concave portion of the convex plate is wiped off; and a method to peel off the ink by an adhesive substrate. However, further improvement is necessary for these cleaning methods.

Also, in a peeling offset printing, to continuously perform the printing operation, similarly to the above case, it is necessary that the waterless flat plate and the blanket are in clean condition after each printing. In the peeling offset printing, the surface of the blanket is reset by completely transferring the ink from the blanket surface to the substrate for printing. Meanwhile, the ink remaining in the waterless flat plate is not removed, and thus an additional cleaning step is necessary.

Also, in micro-contact printing, among the ink coated on the entire surface of the concave and convex plate, the ink on the convex portion of the concave and convex plate is transferred to the substrate for printing, and the ink in the concave portion of the concave and convex plate remains. Accordingly, to perform continuous printing, a step of removing the ink in the concave portion of the concave and convex plate is necessary.

In these manners, conventional printing methods such as reversing offset printing, peeling offset printing, micro-contact printing, are not suitable for continuous printing.

In an embodiment of the present invention, the second substrate of the blanket contains an elastic body swellable in a solvent, so that the second substrate maybe swelled by a solvent. In the blanket, the hydrophilic region is a portion that the second substrate surface is hydrophilized, and the second substrate contains the elastic body swellable in a solvent, so that the solvent in the coating solution for forming functional layer adhered to the hydrophilic region of the blanket may be permeated to the hydrophilic region. Accordingly, since the solvent in the coating solution for forming functional layer is permeated to the hydrophilic region of the blanket from the time the coating solution for forming functional layer is adhered to the hydrophilic region of the blanket to the time of transferring thereof to the hydrophilic portion of the printing plate and to the substrate for forming functional layer, viscosity of the coating solution for forming functional layer is gradually increased together with evaporation of the solvent in the coating solution for forming functional layer; thus, agglutination of the coating solution for forming functional layer on the surface of the hydrophilic region of the blanket may be improved. Thereby, the coating solution for forming functional layer maybe completely transferred when transferring the coating solution for forming functional layer from the blanket to the hydrophilic portion of the printing plate and to the substrate for forming functional layer, so that transferability of the coating solution for forming functional layer from the blanket to the printing plate and to the substrate for forming functional layer may be improved.

Also, by a printing plate of an embodiment of the present invention, as described in "A. Printing plate" above, the coating solution for forming functional layer may be completely transferred when the coating solution for forming functional layer is transferred from the hydrophilic portion of the printing plate to the substrate for cleaning, so that transferability of the coating solution for forming functional layer from the printing plate to the substrate for cleaning may be improved. Further, on the occasion the printing plate is repeatedly used, adhesion of the coating solution for forming functional layer to the surface of the hydrophobic solvent permeation preventing layer may be inhibited, so that occurrence of the base staining may be inhibited.

Accordingly, continuous printing is possible by an embodiment of the present invention.

Also, the coating solution for forming functional layer transferred to the substrate for cleaning may be collected and reused without discarding thereof. Thereby, the unnecessary coating solution for forming functional layer transferred from the blanket to the printing plate may be collected without wasting; thus, a functional element may be produced at low cost.

Also, in a conventional peeling offset printing, the hydrophilic image portion of a waterless flat plate is a grave in micrometer order with respect to the hydrophobic non-image portion, so that it is difficult to transfer the ink from the blanket to the hydrophilic image portion of the waterless flat plate in the same manner as an embodiment of the present invention . Also, the hydrophilic image portion of the waterless flat plate is constituted with a constituent such as a thermosensitive layer, so that the complete transfer of the ink is difficult, and removing the ink remaining in the waterless flat plate is difficult.

In contrast, in an embodiment of the present invention, the elastic body swellable in a solvent is used for the hydrophilic portion of the printing plate, so that the ink of the printing plate may be easily removed.

The producing method for a functional element of an embodiment of the present invention is hereinafter described in each step.

### 1. Printing plate preparing step

A printing plate preparing step in an embodiment of the present invention is a step of preparing a printing plate comprising: a substrate containing an elastic body swellable in a solvent, a hydrophobic solvent permeation preventing layer formed on the substrate in a pattern, and a hydrophilic portion that is formed on a surface of the substrate at an opening portion of the hydrophobic solvent permeation preventing layer and higher in hydrophilicity than the hydrophobic solvent permeation preventing layer, wherein a surface of the hydrophobic solvent permeation preventing layer side of the substrate is flat.

Incidentally, the printing plate and the producing method therefor are described in details in "A. Printing plate" and "B. Producing method for printing plate" above; thus, the descriptions herein are omitted.

### 2. Blanket preparing step

A blanket preparing step in an embodiment of the present invention is a step of preparing a blanket including a second substrate that contains an elastic body swellable in a solvent and includes a hydrophilic region on the surface. The hydrophilic region of the blanket is higher in hydrophilicity than the hydrophobic solvent permeation preventing layer of the printing plate and equal to or lower in hydrophilicity than the hydrophilic portion of the printing plate. Also, the surface of the hydrophilic region side of the blanket is flat.

The second substrate contains an elastic body swellable in a solvent. The second substrate containing the elastic body swellable in a solvent includes elasticity; thus, on the occasion of transferring the coating solution for forming functional layer by adhering the printing plate to the blanket in the later-described first transferring step, and on the occasion of transferring the coating solution for forming functional layer by adhering the substrate for printing to the blanket in the later-described second transferring step, pressure may be uniformly applied to the blanket; also, adhesion of the blanket with the printing plate as well as adhesion of the blanket with the substrate for printing may be increased. Thereby, transferability of the coating solution for forming functional layer may be improved, and thus high-definition printing is possible.

Incidentally, the elastic body swellable in a solvent may be the same as the elastic body swellable in a solvent to be used for the substrate of the printing plate, which is described in detail in "A. Printing plate" above; thus, the description herein is omitted.

Examples of such elastic body swellable in a solvent may include silicone rubber, acrylic rubber, urethanerubber, fluoro rubber, polysulfide rubber, ethylene-propylene rubber, nitrile rubber, butyl rubber, chloroprene rubber, butadiene rubber, and styrene-butadiene rubber. Above all, silicone rubber, acrylic rubber, and urethane rubber are preferable; particularly, silicone rubber is preferable. The reason there for is because these are easily swelled in a solvent included in the later-described coating solution for forming functional layer. Also, in the case of silicone rubber, the complete transfer is easily achieved, and thus transferability may be further improved.

Examples of the material for the silicone rubber to be used for the second substrate may include polydimethylsiloxane and the copolymer thereof, polydimethylsiloxane containing fluorine and the copolymer thereof, polyvinylmethylsiloxane, and polyphenylmethylsiloxane.

Also, examples of the material for acrylic rubber to be used for the second substrate may include ethyl polyacrylate, butyl polyacrylate, and methoxyethyl polyacrylate.

The second substrate may be a single layer that contains the elastic body swellable in a solvent, and may be the one in which an elastic body layer containing the elastic body swellable in a solvent is formed on a supporting body. Examples of the supporting body may include a glass substrate, resin substrate, ceramics substrate, and metal substrate.

Hydrophilicity of the hydrophilic region of the blanket is higher than hydrophilicity of the hydrophobic solvent permeation preventing layer of the printing plate, and equal to or lower than hydrophilicity of the hydrophilic portion; specifically, the contact angle of the hydrophilic region to water of 25°C is lower than the contact angle of the hydrophobic solvent permeation preventing layer of the printing plate and more than the contact angle of the hydrophilic portion. More specifically, the contact angle of the hydrophilic region to water of 25°C is preferably in a range of about 50° or more to 105° or less; above all, preferably in a range of about 70° or more to 105° or less. If the contact angle of the hydrophilic region of the blanket is in the range, difference of the contact angles between the hydrophilic region of the blanket and the hydrophobic solvent permeation preventing layer of the printing plate as well as the difference of the contact angles between the hydrophilic region of the blanket and the hydrophilic portion of the printing plate may be increased so as to improve transferability.

Incidentally, the measuring method for the contact angle is as described above.

Also, difference of the contact angles between the hydrophilic region of the blanket and the hydrophobic solvent permeation preventing layer of the printing plate as well as the difference of the contact angles between the hydrophilic region of the blanket and the hydrophilic portion of the printing plate are preferably larger the better respectively; specifically, preferably 5° or more, and above all, preferably 10° or more. In the same manner as in the above case, if difference of the contact angles between the hydrophilic region of the blanket and the hydrophobic solvent permeation preventing layer of the printing plate as well as the difference of the contact angles between the hydrophilic region of the blanket and the hydrophilic portion of the printing plate are in the range, transferability may be improved.

The hydrophilic region is such that the second substrate surface is hydrophilized. The hydrophilic region is usually formed on the entire surface of the second substrate. Incidentally, hydrophilization of the second substrate surface may be the same as the method described in "B. Producing method for printing plate" above; thus the description herein is omitted.

The shape of the blanket may be a plate shape and may be a roll shape. If the printing plate and the blanket are in a roll shape, continuous printing by a roll-to-roll method is possible.

### 3. Coating step

A coating step of an embodiment of the present invention is a step of coating the hydrophilic region side surface of the blanket with a coating solution for forming functional layer.

Here, "functional" refers to various functions including an optical function such as light selective absorption, reflectivity, polarizability, light selective permeability, nonlinear optical property, luminescence such as fluorescence and phosphorescence, and photochromic property; a magnetic function such as hard magnetism, soft magnetism, non-magnetism, and ceramic property; an electrical or electronical function such as conductivity, insulating property, piezoelectric property, pyroelectric property, and dielectric property; a chemical function such as absorbing property, desorbing property, catalytic property, water absorbing property, ion conductivity, oxidation reduction property, electrochemical property, and electrochromic property; a mechanical function such as wear resisting property; a thermal function such as heat conductivity, heat insulating property, and infrared-radiating property; and a biological function such as biocompatibility, and antithrombotic property.

The coating solution for forming functional layer contains a functional material and solvent.

The functional material is appropriately selected in accordance with factors such as the kind and application of the functional element; examples thereof may include a semiconductor material, luminescent material, hole-injecting material, a conductive material such as metal nanocolloid, coloring material, resin material, and a biological material such as protein, cell, and DNA.

Also, the solvent is preferably the one including permeability to the elastic body swellable in a solvent and volatility. Usage of such solvent allows the complete transfer of the coating solution for forming functional layer. Regarding the permeability and volatility, for example, the descriptions in Patent Document 2 and Patent Document 3 may be referred. In specific, the solvent described in "A. Printing plate 5. Application" above may be exemplified.

The method for coating the surface of the hydrophilic region side of the blanket with the coating solution for forming functional layer is not particularly limited if the method allows the entire surface of the hydrophilic region to be coated with the coating solution for forming functional layer in a uniform thickness; the method may be appropriately selected from general methods such as a spin coat method, die coat method, and bar coat method.

Also, after coating the coating solution for forming functional layer, the solution is preferably dried. The reason therefor is because agglutination of the coating solution for forming functional layer may be increased by drying, and thus the complete transfer of the coating solution for forming functional layer is possible. If the coating solution for forming functional layer contains a volatile solvent, the solution may be naturally dried. Also, the coating solution for forming functional layer may be dried by heating and blowing air for example.

### 4. First transferring step

A first transferring step in an embodiment of the present invention is a step of transferring the coating solution for forming functional layer in the blanket to only the hydrophilic portion of the printing plate by making the blanket to contact with the printing plate via the coating solution for forming functional layer.

The pressure at the time of making the blanket to contact with the printing plate is appropriately adjusted. As described above, in an embodiment of the present invention, the acceptable range of the pressure in the first transferring step maybe widened, and thus printing is possible even when the pressure is comparatively large.

### 5. Second transferring step

A second transferring step of an embodiment of the present invention is a step of forming a functional layer by transferring the coating solution for forming functional layer remaining in the blanket to a substrate for forming functional layer.

Hydrophilicity of the surface of the substrate for forming functional layer is equal to or higher than the hydrophilicity of the hydrophilic region of the blanket; specifically, the contact angle of the surface of the substrate for forming functional layer to water of 25°C is the contact angle of the hydrophilic region of the blanket or less. In more specific, the contact angle of the substrate for forming functional layer to water of 25°C is preferably in a range of about 0° or more to 90° or less, and above all, preferably in a range of about 60° or more to 80° or less. If the contact angle of the substrate for forming functional layer is in the range, difference of the contact angles between the substrate for forming functional layer and the hydrophilic region of the blanket may be increased, and thus transferability may be improved.

Incidentally, the measuring method for the contact angle is as described above.

Also, the difference of the contact angles between the hydrophilic region of the blanket and the substrate for forming functional layer is larger the better; specifically, preferably 5° or more, and above all, preferably 10° or more. Similarly to the above case, if the difference of the contact angles between the hydrophilic region of the blanket and the substrate for forming functional layer are in the range, transferability may be improved.

The substrate for forming functional layer may be a sheet and may be long. If the substrate for forming functional layer is long, continuous printing by a roll-to-roll method is possible.

Pressure for making the blanket to contact with the substrate for forming functional layer is appropriately adjusted. The thickness of the coating film of the coating solution for forming functional layer is appropriately selected in accordance with factors such as the kind and application of the functional element.

### 6. Removing step

In an embodiment of the present invention, it is preferable to perform a removing step of transferring the coating solution for forming functional layer at the hydrophilic portion of the printing plate to a substrate for cleaning.

The surface of the substrate for cleaning is higher in hydrophilicity than the hydrophilic portion of the printing plate. The hydrophilic portion of the printing plate contains the elastic body swellable in a solvent and the surface of the substrate for cleaning is higher in hydrophilicity than the hydrophilic portion of the printing plate, so that the coating solution for forming functional layer may be completely transferred to the substrate for cleaning.

Hydrophilicity of the surface of the substrate for cleaning is higher than hydrophilicity of the hydrophilic portion of the printing plate; specifically, the contact angle of the surface of the substrate for cleaning to water of 25°C is lower than the contact angle of the hydrophilic portion of the printing plate. In more specific, the contact angle of the substrate for cleaning to water of 25°C is preferably in a range of about 0° or more to 60° or less, and above all, preferably in a range of about 0° or more to 30° or less. If the contact angle of the substrate for cleaning is in the range, difference of the contact angles between the substrate for cleaning and the hydrophilic portion of the printing plate may be increased, and thus transferability may be improved.

Incidentally, the measuring method for the contact angle is as described above.

Also, difference of the contact angles between the hydrophilic portion of the printing plate and the substrate for cleaning is larger the more preferable; specifically, preferably 5° or more, and above all, preferably 10° or more. Similarly to the above case, if difference of the contact angles between the hydrophilic portion of the printing plate and the substrate for cleaning are in the range, transferability may be improved.

Also, the substrate for cleaning may include adhesiveness. The hydrophilic portion of the printing plate contains the elastic body swellable in a solvent and the substrate for cleaning includes adhesiveness, so that the coating solution for forming functional layer may be completely transferred to the substrate for cleaning.

For adhesiveness of the substrate for cleaning, the adhesive force is preferably in a range of about 2.0 N/20 mm or more to 20 N/ 20 mm or less. If the adhesive force of the substrate for cleaning is in the range, the intended transferability may be obtained.

Incidentally, the adhesive force is the value measured by the method based on JIS Z 0237.

The substrate for cleaning may be a sheet and may be long. If the substrate for cleaning is long, continuous printing by a roll-to-roll method is possible.

The pressure for making the printing plate to contact with the substrate for cleaning is appropriately adjusted.

### 7. Application

The producing method for a functional element of an embodiment of the present invention may be applied such as to: form an electrode, semiconductor layer, gate insulating layer and between layers insulating layer in a semiconductor element such as a transistor and diode, form a pixel electrode in a TFT substrate, form a rear electrode in a solar cell, form a rear electrode in an organic EL element, form an electrode and polymer layer of a nonvolatile memory, form an electrode and polymer layer of a pressure sensor, form a wiring in a wiring substrate, form a color layer and light-shielding portion in a color filter, and produce a biochip. In particular, the producing method for a functional element of an embodiment of the present invention may be favorably used to produce an electronic device that requires minute patterns.

### D. Printing apparatus

A printing apparatus of an embodiment of the present invention comprises: a printing plate for waterless planographic printing that comprises a substrate containing an elastic body swellable in a solvent in an ink, a hydrophobic solvent permeation preventing layer that is a non-image portion formed on the substrate in a pattern and includes a function of inhibiting permeation of a solvent in an ink, and a hydrophilic portion that is an image portion formed on a surface of the substrate at an opening portion of the hydrophobic solvent permeation preventing layer and higher in hydrophilicity than the hydrophobic solvent permeation preventing layer, wherein a surface of the hydrophobic solvent permeation preventing layer side of the substrate is flat; a blanket including a second substrate that contains an elastic body swellable in a solvent and includes a hydrophilic region on the surface, and disposed so as to be capable of contacting with the printing plate; a coating machine for coating the hydrophilic region side surface of the blanket with an ink; a mounting member for printing that mounts a substrate for printing and is disposed so as to be capable of contacting with the blanket; and a mounting member for cleaning that mounts a substrate for cleaning and is disposed so as to be capable of contacting with the printing plate; wherein the hydrophilic region of the blanket is higher in hydrophilicity than the hydrophobic solvent permeation preventing layer of the printing plate, and is equal to or lower in hydrophilicity than the hydrophilic portion of the printing plate.

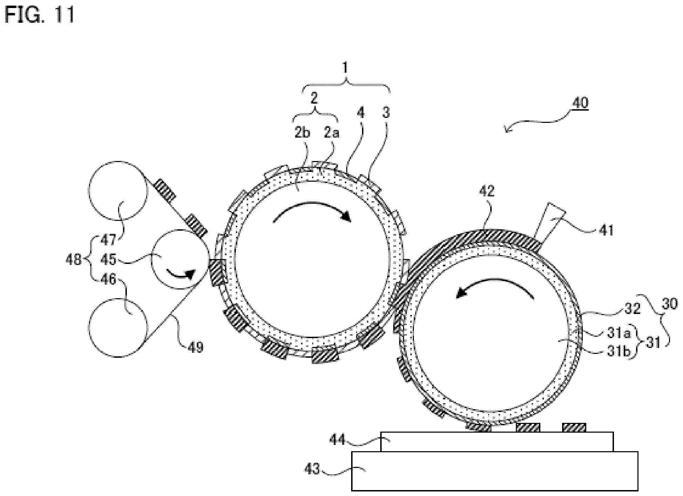

FIG. 11 is a schematic diagram illustrating an example of a printing apparatus of an embodiment of the present invention. Printing apparatus 40 exemplified in FIG. 11 comprises printing plate 1 in a roll shape, blanket 30 in a roll shape disposed so as to be capable of contacting with printing plate 1, coating machine 41 for coating blanket 30 with an ink, mounting member for printing 43 that mounts substrate for printing 44 and is disposed so as to be capable of contacting with blanket 30, and cleaning unit 48 including mounting member for cleaning 45 in a roll shape that mounts substrate for cleaning 49 and is disposed so as to be capable of contacting with printing plate 1. Printing plate 1 comprises substrate 2 in which elastic body layer 2a is formed on supporting body 2b, hydrophobic solvent permeation preventing layer 3 formed on substrate 2 in a pattern, and hydrophilic portion 4 that is formed on a surface of substrate 2 at an opening portion of hydrophobic solvent permeation preventing layer 3 and higher in hydrophilicity than hydrophobic solvent permeation preventing layer 3, wherein a surface of hydrophobic solvent permeation preventing layer 3 side of substrate 2 is a flat curved surface. Blanket 30 includes second substrate 31, in which elastic body layer 31a is formed on supporting body 31b, and that includes hydrophilic region 32 on the surface of elastic body layer 31a. Hydrophilic region 32 of blanket 30 is higher in hydrophilicity than hydrophobic solvent permeation preventing layer 3 of printing plate 1, and equal to or lower in hydrophilicity than hydrophilic portion 4 of printing plate 1. Cleaning unit 48 includes mounting member for cleaning 45 in a roll shape, first roll 46 for feeding substrate for cleaning 49 which is long, and second roll 47 for taking up substrate for cleaning 49 which is long.

In this printing apparatus 1, first, the surface of hydrophilic region 32 side of blanket 30 is coated with ink 42 by coating machine 41, and then blanket 30 is contacted with printing plate 1 via ink 42, so as to transfer ink 42 in blanket 30 only to hydrophilic portion 4 of printing plate 1. Next, ink 42 remaining in blanket 30 is transferred to substrate for printing 44. Also, ink 42 transferred to hydrophilic portion 4 of printing plate 1 is transferred to substrate for cleaning 49 which is long.

In an embodiment of the present invention, as described in "C. Producing method for functional element" above, on the occasion of transferring the ink from the blanket to the hydrophilic portion of the printing plate and transferring the ink from the blanket to the substrate for printing, the complete transfer of the ink is possible by means of not only the difference of hydrophilicity but also by means of WBL, so that transferability may be improved. Also, on the occasion of transferring the ink from the blanket to the hydrophilic portion of the printing plate, the ink is transferred by means of the difference of hydrophilicity and WBL, so that occurrence of printing defect due to the bottom contact maybe inhibited. Thus, printing with high resolution is possible.

Further, in an embodiment of the present invention, the mounting member for cleaning is provided and thus, as described in "A. Printing plate" above, the complete transfer of the ink is possible when transferring the ink from the hydrophilic portion of the printing plate to the substrate for cleaning, so that transferability of the ink from the printing plate to the substrate for cleaning may be improved. Furthermore, on the occasion of using the printing plate continuously, the ink is prevented from adhering to the surface of the hydrophobic solvent permeation preventing layer, and thus occurrence of the base staining may be inhibited. Thereby, continuous printing is possible.

Also, the ink transferred to the substrate for cleaning may be collected and reused without discarding thereof. Accordingly, unnecessary ink transferred from the blanket to the printing plate may be collected without wasting, and thus the cost reduction is also possible.

The printing apparatus of an embodiment of the present invention is hereinafter described in each constitution.

### 1. Printing plate

A printing plate in an embodiment of the present invention comprises a substrate containing an elastic body swellable in a solvent, a hydrophobic solvent permeation preventing layer formed on the substrate in a pattern, and a hydrophilic portion that is formed on a surface of the substrate at an opening portion of the hydrophobic solvent permeation preventing layer and higher in hydrophilicity than the hydrophobic solvent permeation preventing layer, wherein a surface of the hydrophobic solvent permeation preventing layer side of the substrate is flat.

Incidentally, the printing plate is described in details in "A. Printing plate" above; thus, the description herein is omitted.

### 2. Blanket

A blanket in an embodiment of the present invention includes a second substrate that contains an elastic body swellable in a solvent and includes a hydrophilic region on the surface, and is disposed so as to be capable of contacting with the printing plate. The hydrophilic region of the blanket is higher in hydrophilicity than the hydrophobic solvent permeation preventing layer of the printing plate and equal to or lower in hydrophilicity than the hydrophilic portion of the printing plate.

Incidentally, the blanket is described in details in "C. Producing method for functional element" above; thus the description herein is omitted.

The blanket is disposed so as to be capable of contacting with the printing plate, and the position is appropriately selected in accordance with the shape of the blanket.

### 3. Coating machine

A coating machine of an embodiment of the present invention is to coat the surface of the hydrophilic region side of the blanket with an ink.

The coating machine is not particularly limited if it is capable of coating the entire surface of the hydrophilic region of the blanket with the ink in a uniform thickness; for example, it may be appropriately selected from general coating machines such as a spin coater, die coater, and bar coater.

### 4. Mounting member for printing

A mounting member for printing in an embodiment of the present invention is disposed so as to be capable of contacting with the blanket, and mounts a substrate for printing.

The shape of the mounting member for printing may be a plate shape and may be a roll shape. If the mounting member for printing is in a roll shape, continuous printing by a roll-to-roll method is possible.

The mounting member for printing is disposed so as to be capable of contacting with the blanket, and the position is appropriately selected in accordance with the shape of the mounting member for printing.

### 5. Mounting member for cleaning

A mounting member for cleaning in an embodiment of the present invention is disposed so as to be capable of contacting with the printing plate, and mounts a substrate for cleaning.

The shape of the mounting member for cleaning may be a plate shape and may be a roll shape. If the mounting member for cleaning is in a roll shape, continuous printing by a roll-to-roll method is possible.

Also, if the mounting member for cleaning is in a roll shape, the printing apparatus of an embodiment of the present invention is preferably provided with a cleaning unit including a mounting member for cleaning in a roll shape, a first roll for feeding a substrate for cleaning which is long, and a second roll for taking up the substrate for cleaning which is long. The reason therefor is to maintain the surface of the substrate for cleaning, which contacts with the printing plate, always in clean condition.

The mounting member for cleaning is disposed so as to be capable of contacting with the printing plate, and the position is appropriately selected in accordance with the shape of the mounting member for cleaning.

The present disclosure is not limited to the embodiments. The embodiments are exemplification.

### Examples

Embodiments of the present invention are hereinafter described in further detail with reference to examples and comparative examples.

### [Example 1] Production of printing plate for planographic printing with silicone rubber

### (Production of substrate)

A glass substrate was spin coated with Shin-Etsu silicone KE106 manufactured by Shin-Etsu Chemical Co., Ltd., which is an undiluted solution of silicone rubber, by spin coater MS-A100 manufactured by MIKASA CO., LTD, thereafter heated on hot plate ND-1 manufactured by AS ONE CORPORATION at 160°C for 1 hour to form a silicone rubber layer. The contact angle of this silicone rubber layer to pure water measured by contact angle meter DM-901 manufactured by Kyowa Interface Science Co., Ltd. was 107 ± 4°. Also, the thickness of the silicone rubber layer measured by Standard Digimatic Caliper manufactured by Mitutoyo Corporation was 620 µm.

The surface of the silicone rubber layer was subjected to an oxygen plasma treatment by plasma cleaner V1000 manufactured by YAMATO SCIENTIFIC CO., LTD. to hydrophilize the entire surface. The contact angle of the silicone rubber layer to pure water after the hydrophilization was 10 ± 2°.

### (Formation of hydrophobic solvent permeation preventing layer)

The hydrophilized silicone rubber layer surface was spin coated with a polymer of fluorinated alkylpolysiloxane FAS-17, thereafter burned on a hot plate at 150°C for 10 minutes to form a hydrophobic solvent permeation preventing layer. The copolymer of FAS-17 was prepared by mixing 1H, 1H, 2H, 2H-Perfluorodecyltriethoxysilane manufactured by Sigma-Aldrich and 0.05N aqueous hydrochloric acid at the ratio of 10 : 1 and stirring thereof for 12 hours. The contact angle of the hydrophobic solvent permeation preventing layer to pure water was 110 ± 7°.

### (Patterning of plate)

The surface of the hydrophobic solvent permeation preventing layer is spin coated with a photoresist such that a small amount of surfactant F444 manufactured byDIC Corporation was added to photoresist AZ1500 manufactured by AZ Electronic Materials, thereafter exposed to light of 365 nm via a photomask by LED NC4U134A manufactured by Nichia Corporation, and then developed by developing solution NMD-W manufactured by TOKYO OHKA KOGYO CO., LTD. in a metal vat. Thereby, a resist pattern including the line and space (L/S) : 10/10 µm was obtained. The step of the thickness and Ra of the resist measured by Surfcorder SE4000 manufactured by Kosaka Laboratory Ltd. were 5 ± 0.1 µm for the thickness, and 10 nm for Ra.

The resist-pat tern-formed hydrophobic solvent permeation preventing layer and the silicone rubber layer were subjected to an oxygen plasma treatment so as to hydrophilize the entire surface. On this occasion, the surface of the hydrophobic solvent permeation preventing layer at the opening portion of the resist pattern was directly disposed to the plasma treatment so that the hydrophobic solvent permeation preventing layer was removed, and further, the surface of the exposed silicone rubber layer was hydrophilized.

Again, the entire surface of the resist-pattern-formed silicone rubber layer was irradiated with the LED of 365 nm, thereafter soaked in the developing solution in a metal vat to remove the resist pattern. When the wettability of the surface was evaluated, while the contact angle of the exposed silicone rubber layer to pure water was 60 ± 3° which was hydrophilic, the contact angle of the hydrophobic solvent permeation preventing layer to pure water was 107 ± 5° which was hydrophobic. Also, from the step measurement of the surface, the grave of 30 nm was formed in the exposed portion of the silicone rubber layer with respect to the hydrophobic solvent permeation preventing layer. The border between the steps was well corresponded to the border between the hydrophilic region and the hydrophobic region; a printing plate for planographic printing with resolution of L/S: 10/10 µm similar to the resist pattern was obtained.

### [Example 2] Production of printing plate for intaglio printing with silicone rubber

### (Production of substrate and formation of hydrophobic solvent permeation preventing layer)

A substrate was produced and then a hydrophobic solvent permeation preventing layer was formed in the same manner as in Example 1.

### (Patterning of plate)

A resist pattern was formed on the surface of the hydrophobic solvent permeation preventing layer in the same manner as in Example 1.

The resist-pattern-formed hydrophobic solvent permeation preventing layer and the silicone rubber layer were subjected to a plasma treatment with a mixed gas of oxygen and CF₄ by plasma cleaner V1000 manufactured by YAMATO SCIENTIFIC CO., LTD., thereafter subjected to oxygen plasma treatment without opening the batch. On this occasion, at the opening portion of the resist pattern, the hydrophobic solvent permeation preventing layer was removed by a dry etching treatment with the plasma of the first mixed gas and the exposed silicone rubber layer was removed as well; subsequently, the surface of the exposed silicone rubber layer was further hydrophilized by the oxygen plasma.

The resist pattern was removed in the same manner as in Example 1. When the wettability of the surface was evaluated, while the contact angle of the exposed silicone rubber layer to pure water was 60 ± 3° which was hydrophilic, the contact angle of the hydrophobic solvent permeation preventing layer to pure water was 107 ± 5° which was hydrophobic. Also, from the step measurement of the surface, the grave of 4.1 ± 0.1 µm was formed in the exposed portion of the silicone rubber layer with respect to the hydrophobic solvent permeation preventing layer. The border between the steps was well corresponded to the border between the hydrophilic region and the hydrophobic region; a printing plate for intaglio printing with hydrophilic and hydrophobic effect and resolution of L/S: 10/10 µm similar to the resist pattern was obtained.

### [Comparative Example 1]

A silicone rubber layer was formed on a glass substrate in the same manner as in Example 1.

A resist pattern was formed on the surface of the silicone rubber layer in the same manner as in Example 1. The resist pattern was swelled by the backflow of the solvent in the photoresist permeated to the silicone rubber layer, and thus the resist pattern intended with L/S: 10/10 µm resulted in 16/4 µm. On the other hand, when the pattern was with low resolution which was less than L/S: 50/50 µm, the resist pattern was formed as intended. Also, the surface and side of the resist pattern were rough due to the swelling; thus, as the result of the step measurement, resolution was deteriorated in which Ra was 1.3 µm. In these manners, formation of the resist pattern with high definition was difficult.

### [Example 3] Production of electrode for organic thin film transistor (OTFT)

### (Production of printing plate)

A printing plate for planographic printing was produced in the same manner as in Example 1 except that the one including patterns corresponding to a source electrode and drain electrode for OTFT was used as the photomask. On the surface of the plate, the region corresponding to the source electrode and drain electrode was hydrophobic region, and the rest was hydrophilic region.

### (Production of blanket)

The surface of PEN film Q65FA manufactured by Teijin DuPont Films Japan Limited was washed by a vacuum ultraviolet treatment using light irradiating device UER616908-172 manufactured by USHIO INC. Next, PEN film was spin coated with uncured silicone rubber KE106 manufactured by Shin-Etsu Chemical Co., Ltd. using spin coater MS-300 manufactured by MIKASA CO., LTD, thereafter burned in oven DE410 manufactured by YAMATO SCIENTIFIC CO., LTD. at 160°C for 1 hour to produce a blanket including a silicone rubber layer. The thickness of the silicone rubber layer measured by *Nogisu* CD67 - S PS manufactured by Mitutoyo Corporation was 0.75 ± 0.01 mm. Also, the contact angle of the surface of the silicone rubber layer to pure water measured by contact angle meter DM-901 manufactured by Kyowa Interface Science Co., Ltd. was 107 ± 3°. The surface was subjected to the vacuum ultraviolet treatment so as to bring the contact angle to pure water to be 79 ± 2°.

### (Preparation of substrate for cleaning)

The surface of PEN film Q65FA manufactured by Teijin DuPont Films Japan Limited was subjected to a vacuum ultraviolet treatment by using irradiation device UER616908-172 manufactured by USHIO INC., thereafter the surface was washed and hydrophilized at the same time. The contact angle of the surface of PEN film to pure water measured by contact angle meter DM-901 manufactured by Kyowa Interface Science Co., Ltd. was 17 ± 6°.

### (Printing source electrode and drain electrode)

A silicon substrate including a silicon oxide film of 200 nm on the surface was prepared as the substrate for forming functional layer.

Silver paste GOAGT manufactured by DIC Corporation was used as the ink; the ink was pasted over the blanket by a doctor blade, dried at room temperature for 30 seconds, thereafter the blanket was contacted with the printing plate by using hand roller *Micro Catch* manufactured by Katsura Roller Mfg. Co., Ltd.; thereby, the ink was transferred from the blanket to the hydrophilic portion of the printing plate. Here, on the surface of the blanket, the same shape of the hydrophobic region of the printing plate, that is the pattern shape corresponding to the source electrode and drain electrode of OTFT was left. Next, likewise, when the blanket was contacted with the substrate for forming functional layer by using the hand roller, the ink was transferred from the blanket to the substrate for forming functional layer and the pattern of the silver paste was formed on the silicon substrate. Also, the surface of the blanket was cleaned.

Next, when the substrate for cleaning was pushed onto the printing plate by using the hand roller, the ink adhered to the surface of the hydrophilic region of the printing plate was transferred to the substrate for cleaning and the printing plate was cleaned. Both the blanket and the printing plate were cleaned so that next printing was performed in the same manner.

### (Production and evaluation of OTFT)

Next, the silicon substrate in which the silver paste pattern was formed was burned in oven DE410 manufactured by YAMATO SCIENTIFIC CO., LTD. at 160°C for 1 hour, so that the ink was burned and a source electrode and drain electrode were formed.

Next, the surface of the silicon substrate was spin coated with organic semiconductor ink Plexore™ OS2100 manufactured by Sigma-Aldrich Co. LLC by spin coater MS-300 manufactured by MIKASA CO., LTD. to form an organic semiconductor layer. Produced thereby was an OTFT comprising a gate electrode constituted with the silicon substrate, gate insulating layer constituted with the silicon oxide film, printed source electrode and drain electrode, and the organic semiconductor layer.

Electric property of the OTFT was evaluated; as the result, mobility shown was 0. 01 ± 0. 003 cm²/Vs, which functioned normally.

### [Example 4] Production of printing plate for planographic printing with acrylic rubber

### (Production of substrate)

A glass substrate was spin coated with acrylic rubber undiluted solution Nipol™ AR12 manufactured by ZEON CORPORATION by spin coater MS-A100 manufactured by MIKASA CO., LTD., thereafter heated on hot plate ND-1 manufactured by AS ONE CORPORATION at 160°C for 1 hour to form an acrylic rubber layer. The contact angle of this acrylic rubber layer to pure water measured by contact angle meter DM-901 manufactured by Kyowa Interface Science Co., Ltd. was 90 ± 3°. Also, the thickness of the acrylic rubber layer measured by Digimatic Caliper manufactured by Mitutoyo Corporation was 1000 µm.

The surface of the acrylic rubber layer was subjected to an oxygen plasma treatment by plasma cleaner V1000 manufactured by YAMATO SCIENTIFIC CO., LTD. to hydrophilize the entire surface. The contact angle of the acrylic rubber layer to pure water after hydrophilization was 10 ± 2°.

### (Forming hydrophobic solvent permeation preventing layer)

A hydrophobic solvent permeation preventing layer was formed in the same manner as in Example 1. The contact angle of the hydrophobic solvent permeation preventing layer to pure water was 110 ± 7°.

### (Patterning of plate)

A plate was patterned in the same manner as in Example 1. When wettability of the surface after removing the resist pattern was evaluated, while the contact angle of the exposed acrylic rubber layer to pure water was 50 ± 2° which was hydrophilic, the contact angle of the hydrophobic solvent permeation preventing layer to pure water was 107 ± 5° which was hydrophobic. Also, from the step measurement in the surface, the grave of 30 nm was formed in the exposed portion of the acrylic rubber layer with respect to the hydrophobic solvent permeation preventing layer. The border between the steps and the border between the hydrophilic region and hydrophobic region were well corresponded; a printing plate for planographic printing with resolution of L/S: 10/10 µm similar to the resist pattern was obtained.

### [Example 5]

### (Production of printing plate)

A printing plate was produced in the same manner as in Example 3 except that the temperature for curing the silicone rubber was changed to 80°C, 160°C, and 250°C from that in production of substrate in Example 1. Incidentally, the time for curing the silicone rubber was the same as in Example 1. The degrees of rubber hardness of the silicone rubber layer were: 57° when the curing temperature was 80°C, 79° when the curing temperature was 160°C, and 91° when the curing temperature was 250°C.

### (Printing source electrode and drain electrode)

The source electrode and drain electrode were printed by the obtained printing plate in the same manner as in Example 3. The complete transfer from the blanket to the printing plate and to the substrate for forming functional layer was possible in each case. Also, when the degree of rubber hardness of the silicone rubber layer was 79°, the design of the printing plate was printed as it was. On the other hand, when the degree of rubber hardness of the silicone rubber layer was 57°, the width of the pattern became a little larger compared with when the degree of rubber hardness of the silicone rubber layer was 79°. Also, when the degree of rubber hardness of the silicone rubber layer was 91°, the design of the printing plate was printed as it was; however, cleaning of the printing plate by the transferring method was a little more difficult compared with when the degree of rubber hardness of the silicone rubber layer was 79°.

### Reference Signs List

- 1 ...: printing plate
- 2 ...: substrate
- 2a ...: elastic body layer
- 2b ...: supporting body
- 3 ...: hydrophobic solvent permeation preventing layer
- 4 ...: hydrophilic portion
- 5 ...: concave portion
- 11 ...: resist pattern
12 ... oxidization treatment
13 ... physical treatment
14, 15 ... hydrophilic treatment
21, 42 ... ink
22, 44 ... substrate for printing
30 ... blanket
31 ... second substrate
31a ... elastic body layer
31b ... supporting body
32 ... hydrophilic region
35 ... coating solution for forming functional layer
36 ... substrate for forming functional layer
38 ... substrate for cleaning
40 ... printing apparatus
41 ... coating machine
43 ... mounting member for printing
45 ... mounting member for cleaning
46 ... first roll
47 ... second roll
48 ... cleaning unit
49 ... substrate for cleaning

## Claims

1. A printing plate (1) for waterless planographic printing or intaglio printing comprising:
a substrate (2) containing an elastic body swellable in a solvent in an ink,
a hydrophobic solvent permeation preventing layer (3) that is a non-image portion formed on the substrate in a pattern and includes a function of inhibiting permeation of a solvent in an ink, and
a hydrophilic portion (4) that is an image portion formed on a surface of the substrate (2) at an opening portion of the hydrophobic solvent permeation preventing layer (3) and higher in hydrophilicity than the hydrophobic solvent permeation preventing layer (3).

2. The printing plate (1) according to claim 1, **characterized in that** the elastic body is silicone rubber, acrylic rubber, urethane rubber, fluoro rubber, polysulfide rubber, ethylene-propylene rubber, nitrile rubber, butyl rubber, chloroprene rubber, butadiene rubber, or styrene-butadiene rubber.

3. The printing plate (1) according to claim 1 or 2, **characterized in that** a surface of the hydrophobic solvent permeation preventing layer (3) side of the substrate (2) is flat.

4. The printing plate (1) according to claim 1 or 2, **characterized in that** the surface of the substrate (2) includes a concave portion at the opening portion of the hydrophobic solvent permeation preventing layer (3).

5. A producing method for a printing plate (1) for waterless planographic printing or intaglio printing comprising:
a hydrophobic solvent permeation preventing layer forming step of forming a hydrophobic solvent permeation preventing layer (3) including a function of inhibiting permeation of a solvent in an ink on a substrate (2) containing an elastic body swellable in a solvent in an ink;
a resist pattern forming step of forming a resist pattern (11) on the hydrophobic solvent permeation preventing layer (3) ;
a removing and hydrophilizing step of removing the hydrophobic solvent permeation preventing layer (3) atanopening portion of the resist pattern (11), and hydrophilizing the exposed substrate surface to form a hydrophilic portion (4) that is higher in hydrophilicity than the hydrophobic solvent permeation preventing layer (3) ; and
a resist pattern peeling step of peeling the resist pattern (11); wherein
the method allows a printing plate (1) with the hydrophilic portion (4) as an image portion and the hydrophobic solvent permeation preventing layer (3) surface as a non-image portion to be obtained.

6. The producing method for a printing plate (1) according to claim 5, **characterized in that** the elastic body is silicone rubber, acrylic rubber, urethane rubber, fluoro rubber, polysulfide rubber, ethylene-propylene rubber, nitrile rubber, butyl rubber, chloroprene rubber, butadiene rubber, or styrene-butadiene rubber.

7. The producing method for a printing plate (1) according to claim 5 or 6, further comprising a pre-treating step of hydrophilizing the substrate surface before the hydrophobic solvent permeation preventing layer forming step.

8. The producing method for a printing plate (1) according to any one of claims 5 to 7, **characterized in that** the removing and hydrophilizing step comprises: a removing step of removing the hydrophobic solvent permeation preventing layer (3) at the opening portion of the resist pattern (11) and further removing the exposed substrate surface to form a concave portion on the substrate surface; and a hydrophilizing step of hydrophilizing the exposed substrate surface.

9. A producing method for a functional element comprising:
a printing plate preparing step of preparing a printing plate (1) for waterless planographic printing comprising: a substrate (2) containing an elastic body swellable in a solvent in an ink, a hydrophobic solvent permeation preventing layer (3) that is a non-image portion formed on the substrate (2) in a pattern and includes a function of inhibiting permeation of a solvent in an ink, and a hydrophilic portion (4) that is an image portion formed on a surface of the substrate (2) at an opening portion of the hydrophobic solvent permeation preventing layer (3) and higher in hydrophilicity than the hydrophobic solvent permeation preventing layer (3); wherein a surface of the hydrophobic solvent permeation preventing layer side of the substrate (2) is flat;
a blanket preparing step of preparing a blanket (30) including a second substrate (31) that contains an elastic body swellable in a solvent and includes a hydrophilic region (32) on the surface;
a coating step of coating the hydrophilic region (32) side surface of the blanket (30) with a coating solution for forming functional layer (35);
a first transferring step of transferring the coating solution for forming functional layer (35) in the blanket (30) to only the hydrophilic portion (4) of the printing plate (1) by making the blanket (30) to contact with the printing plate (1) via the coating solution for forming functional layer (35) ; and
a second transferring step of forming a functional layer by transferring the coating solution for forming functional layer (35) remaining in the blanket (30) to a substrate for forming functional layer (36);
wherein the hydrophilic region of the blanket is higher in hydrophilicity than the hydrophobic solvent permeation preventing layer of the printing plate, and is equal to or lower in hydrophilicity than the hydrophilic portion of the printing plate (1).

10. The producing method for a functional element according to claim 9, **characterized in that** the elastic body is silicone rubber, acrylic rubber, urethane rubber, fluoro rubber, polysulfide rubber, ethylene-propylene rubber, nitrile rubber, butyl rubber, chloroprene rubber, butadiene rubber, or styrene-butadiene rubber.

11. The producing method for a functional element according to claim 9 or 10, further comprising a removing step of transferring the coating solution for forming functional layer (35) at the hydrophilic portion (4) of the printing plate (1) to a substrate for cleaning.

12. A printing apparatus (40) comprising:
a printing plate (1) for waterless planographic printing that comprises a substrate (2) containing an elastic body swellable in a solvent in an ink, a hydrophobic solvent permeation preventing layer (3) that is a non-image portion formed on the substrate (2) in a pattern and includes a function of inhibiting permeation of a solvent in an ink, and a hydrophilic portion (4) that is an image portion formed on a surface of the substrate (2) at an opening portion of the hydrophobic solvent permeation preventing layer (3) and higher in hydrophilicity than the hydrophobic solvent permeation preventing layer (3); wherein a surface of the hydrophobic solvent permeation preventing layer (3) side of the substrate (2) is flat;
a blanket (30) including a second substrate (31) that contains an elastic body swellable in a solvent and includes a hydrophilic region (32) on the surface, and disposed so as to be capable of contacting with the printing plate (1);
a coating machine (41) for coating the hydrophilic region side surface of the blanket (30) with an ink;
a mounting member for printing (43) that mounts a substrate for printing (44) and is disposed so as to be capable of contacting with the blanket (30); and
a mounting member for cleaning (45) that mounts a substrate for cleaning (49) and is disposed so as to be capable of contacting with the printing plate (1);
wherein the hydrophilic region (32) of the blanket (30) is higher in hydrophilicity than the hydrophobic solvent permeation preventing layer (3) of the printing plate (1), and is equal to or lower in hydrophilicity than the hydrophilic portion (4) of the printing plate (1).

13. The printing apparatus (40) according to claim 12, **characterized in that** the elastic body is silicone rubber, acrylic rubber, urethane rubber, fluoro rubber, polysulfide rubber, ethylene-propylene rubber, nitrile rubber, butyl rubber, chloroprene rubber, butadiene rubber, or styrene-butadiene rubber.

14. The printing apparatus (40) according to claim 12 or 13, **characterized in that** the printing plate (1), the blanket (30), and the mounting member for cleaning (45) are in a roll shape; and the printing apparatus (40) further comprises a cleaning unit (48) that includes the roll shape mounting member for cleaning (45), a first roll (46) for feeding the substrate for cleaning (49) which is long, and a second roll (47) for taking up the substrate for cleaning (49).

## Patentansprüche

1. Druckplatte (1) für einen wasserlosen Flachdruck oder Tiefdruck, die Folgendes umfasst:
ein Substrat (2), das einen elastischen Körper enthält, der in einem Lösungsmittel in einer Tinte quellbar ist,
eine hydrophobe Lösungsmittelpermeationsverhinderungsschicht (3), die ein Nichtbildabschnitt ist, der auf dem Substrat in einem Muster ausgebildet ist und eine Funktion zum Hemmen von Permeation eines Lösungsmittels in einer Tinte beinhaltet und
einen hydrophilen Abschnitt (4), der ein Bildabschnitt ist, der auf einer Oberfläche des Substrats (2) an einem Öffnungsabschnitt der hydrophoben Lösungsmittelpermeationsverhinderungsschicht (3) ausgebildet ist und eine höhere Hydrophilie als die hydrophobe Lösungsmittelpermeationsverhinderungsschicht (3) besitzt.

2. Druckplatte (1) nach Anspruch 1, **dadurch gekennzeichnet, dass** der elastische Körper Siliconkautschuk, Acrylkautschuk, Urethankautschuk, Fluorkautschuk, Polysulfidkautschuk, Ethylen-Propylen-Kautschuk, Nitrilkautschuk, Butylkautschuk, Chloroprenkautschuk, Butadienkautschuk, oder Styrol-Butadien-Kautschuk ist.

3. Druckplatte (1) nach Anspruch 1 oder 2, **dadurch gekennzeichnet, dass** eine Oberfläche der Seite der hydrophoben Lösungsmittelpermeationsverhinderungsschicht (3) des Substrats (2) flach ist.

4. Druckplatte (1) nach Anspruch 1 oder 2, **dadurch gekennzeichnet, dass** die Oberfläche des Substrats (2) einen konkaven Abschnitt an dem Öffnungsabschnitt der hydrophoben Lösungsmittelpermeationsverhinderungsschicht (3) beinhaltet.

5. Herstellungsverfahren für eine Druckplatte (1) für einen wasserlosen Flachdruck oder Tiefdruck, das Folgendes umfasst:
einen Schritt zum Ausbilden einer hydrophoben Lösungsmittelpermeationsverhinderungsschicht zum Ausbilden einer hydrophoben Lösungsmittelpermeationsverhinderungsschicht (3), die eine Funktion zum Hemmen von Permeation eines Lösungsmittels in einer Tinte auf einem Substrat (2) beinhaltet, das einen elastischen Körper enthält, der in einem Lösungsmittel in einer Tinte quellbar ist;
einen Resistmusterausbildungsschritt zum Ausbilden eines Resistmusters (11) auf der hydrophoben Lösungsmittelpermeationsverhinderungsschicht (3);
einen Entfernungs- und Hydrophilisierungsschritt zum Entfernen der hydrophoben Lösungsmittelpermeationsverhinderungsschicht (3) an einem Öffnungsabschnitt des Resistmusters (11) und Hydrophilisieren der freiliegenden Substratoberfläche, um einen hydrophilen Abschnitt (4) auszubilden, der eine höhere Hydrophilie als die hydrophobe Lösungsmittelpermeationsverhinderungsschicht (3) besitzt; und
einen Resistmusterablöseschritt zum Ablösen des Resistmusters (11);
wobei das Verfahren es ermöglicht, eine Druckplatte (1) mit dem hydrophilen Abschnitt (4) als einen Bildabschnitt und die Oberfläche der hydrophoben Lösungsmittelpermeationsverhinderungsschicht (3) als einen Nichtbildabschnitt zu erhalten.

6. Herstellungsverfahren für eine Druckplatte (1) nach Anspruch 5, **dadurch gekennzeichnet, dass** der elastische Körper Siliconkautschuk, Acrylkautschuk, Urethankautschuk, Fluorkautschuk, Polysulfidkautschuk, Ethylen-Propylen-Kautschuk, Nitrilkautschuk, Butylkautschuk, Chloroprenkautschuk, Butadienkautschuk oder Styrol-Butadien-Kautschuk ist.

7. Herstellungsverfahren für eine Druckplatte (1) nach Anspruch 5 oder 6, das ferner einen Vorbehandlungsschritt zum Hydrophilisieren der Substratoberfläche vor dem Schritt zum Ausbilden der hydrophoben Lösungsmittelpermeationsverhinderungsschicht umfasst.

8. Herstellungsverfahren für eine Druckplatte (1) nach einem der Ansprüche 5 bis 7, **dadurch gekennzeichnet, dass** der Entfernungs- und Hydrophilisierungsschritt Folgendes umfasst:
einen Entfernungsschritt zum Entfernen der hydrophoben Lösungsmittelpermeationsverhinderungsschicht (3) an dem Öffnungsabschnitt des Resistmusters (11) und weiteren Entfernen der freiliegenden Substratoberfläche, um einen konkaven Abschnitt auf der Substratoberfläche auszubilden; und einen Hydrophilisierungsschritt zum Hydrophilisieren der freiliegenden Substratoberfläche.

9. Herstellungsverfahren für ein Funktionselement, das Folgendes umfasst:
einen Druckplattenvorbereitungsschritt zum Vorbereiten einer Druckplatte (1) für den wasserlosen Flachdruck, der Folgendes umfasst: ein Substrat (2), das einen elastischen Körper enthält, der in einem Lösungsmittel in einer Tinte quellbar ist, eine hydrophobe Lösungsmittelpermeationsverhinderungsschicht (3), die ein Nichtbildabschnitt ist, der auf dem Substrat (2) in einem Muster ausgebildet ist und eine Funktion zum Hemmen von Permeation eines Lösungsmittels in einer Tinte beinhaltet und einen hydrophilen Abschnitt (4), der ein Bildabschnitt ist, der auf einer Oberfläche des Substrats (2) an einem Öffnungsabschnitt der hydrophoben Lösungsmittelpermeationsverhinderungsschicht (3) ausgebildet ist und eine höhere Hydrophilie als die hydrophobe Lösungsmittelpermeationsverhinderungsschicht (3) besitzt; wobei eine Oberfläche der Seite der hydrophoben Lösungsmittelpermeationsverhinderungsschicht des Substrats (2) flach ist;
einen Gummituchvorbereitungsschritt zum Vorbereiten eines Gummituchs (30), das ein zweites Substrat (31) beinhaltet, das einen elastischen Körper enthält, der in einem Lösungsmittel quellbar ist und einen hydrophilen Bereich (32) auf der Oberfläche beinhaltet;
einen Beschichtungsschritt zum Beschichten der Seitenoberfläche des hydrophilen Bereichs (32) des Gummituchs (30) mit einer Beschichtungslösung zum Ausbilden einer Funktionsschicht (35);
einen ersten Übertragungsschritt zum Übertragen der Beschichtungslösung zum Ausbilden einer Funktionsschicht (35) in dem Gummituch (30) auf nur den hydrophilen Abschnitt (4) der Druckplatte (1), indem das Gummituch (30) über die Beschichtungslösung zum Ausbilden der Funktionsschicht (35) mit der Druckplatte in Berührung gebracht wird (1); und
einen zweiten Übertragungsschritt zum Ausbilden einer Funktionsschicht durch Übertragen der Beschichtungslösung zum Ausbilden der Funktionsschicht (35), die in dem Gummituch (30) verbleibt, auf ein Substrat zum Ausbilden der Funktionsschicht (36);
wobei der hydrophile Bereich des Gummituchs eine höhere Hydrophilie als die hydrophobe Lösungsmittelpermeationsverhinderungsschicht der Druckplatte besitzt und eine gleiche oder eine geringere Hydrophilie als der hydrophile Abschnitt der Druckplatte (1) besitzt.

10. Herstellungsverfahren für ein Funktionselement nach Anspruch 9, **dadurch gekennzeichnet, dass** der elastische Körper Siliconkautschuk, Acrylkautschuk, Urethankautschuk, Fluorkautschuk, Polysulfidkautschuk, Ethylen-Propylen-Kautschuk, Nitrilkautschuk, Butylkautschuk, Chloroprenkautschuk, Butadienkautschuk, oder Styrol-Butadien-Kautschuk ist.

11. Herstellungsverfahren für ein Funktionselement nach Anspruch 9 oder 10, das ferner einen Entfernungsschritt zum Übertragen der Beschichtungslösung zum Ausbilden der Funktionsschicht (35) an dem hydrophilen Abschnitt (4) der Druckplatte (1) auf ein Substrat zum Reinigen umfasst.

12. Druckvorrichtung (40), die Folgendes umfasst:
eine Druckplatte (1) für den wasserlosen Flachdruck, die ein Substrat (2) umfasst, das einen elastischen Körper enthält, der in einem Lösungsmittel in einer Tinte quellbar ist, eine hydrophobe Lösungsmittelpermeationsverhinderungsschicht (3), die ein Nichtbildabschnitt ist, der auf dem Substrat (2) in einem Muster ausgebildet ist und eine Funktion zum Hemmen von Permeation eines Lösungsmittels in einer Tinte beinhaltet und einen hydrophilen Abschnitt (4), der ein Bildabschnitt ist, der auf einer Oberfläche des Substrats (2) an einem Öffnungsabschnitt der hydrophoben Lösungsmittelpermeationsverhinderungsschicht (3) ausgebildet ist und eine höhere Hydrophilie als die hydrophobe Lösungsmittelpermeationsverhinderungsschicht (3) besitzt; wobei eine Oberfläche der Seite der hydrophoben Lösungsmittelpermeationsverhinderungsschicht (3) des Substrats (2) flach ist;
ein Gummituch (30), das ein zweites Substrat (31) beinhaltet, das einen elastischen Körper enthält, der in einem Lösungsmittel in einer Tinte quellbar ist und einen hydrophilen Bereich (32) auf der Oberfläche beinhaltet und so angeordnet ist, dass es zum Inberührungbringen mit der Druckplatte (1) fähig ist;
eine Beschichtungsmaschine (41) zum Beschichten der Seitenoberfläche des hydrophilen Bereichs des Gummituchs (30) mit einer Tinte;
ein Befestigungsbauteil zum Drucken (43), das ein Substrat zum Drucken (44) befestigt und so angeordnet ist, dass es zum Inberührungbringen mit dem Gummituch (30) fähig ist; und
ein Befestigungsbauteil zum Reinigen (45), das ein Substrat zum Reinigen (49) befestigt und so angeordnet ist, dass es zum Inberührungbringen mit der Druckplatte (1) fähig ist;
wobei der hydrophile Bereich (32) des Gummituchs (30) eine höhere Hydrophilie als die hydrophobe Lösungsmittelpermeationsverhinderungsschicht (3) der Druckplatte (1) besitzt und eine gleiche oder geringere Hydrophilie als der hydrophile Abschnitt (4) der Druckplatte (1) besitzt.

13. Druckvorrichtung (40) nach Anspruch 12, **dadurch gekennzeichnet, dass** der elastische Körper Siliconkautschuk, Acrylkautschuk, Urethankautschuk, Fluorkautschuk, Polysulfidkautschuk, Ethylen-Propylen-Kautschuk, Nitrilkautschuk, Butylkautschuk, Chloroprenkautschuk, Butadienkautschuk, oder Styrol-Butadien-Kautschuk ist.

14. Druckvorrichtung (40) nach Anspruch 12 oder 13, **dadurch gekennzeichnet, dass** die Druckplatte (1), das Gummituch (30) und das Befestigungsbauteil zum Reinigen (45) in einer Rollenform vorliegen; und die Druckvorrichtung (40) ferner eine Reinigungseinheit (48) umfasst, die das rollenförmige Befestigungsbauteil zum Reinigen (45), eine erste Rolle (46) zum Zuführen des Substrats zum Reinigen (49), die lang ist, und eine zweite Rolle (47) zum Aufnehmen des Substrats zum Reinigen (49) beinhaltet.

## Revendications

1. Plaque d'impression (1) pour impression planographique sans eau ou impression en relief comprenant :
un substrat (2) contenant un corps élastique dilatable dans un solvant dans une encre,
une couche empêchant la perméation de solvant hydrophobe (3) qui est une partie sans image formée sur le substrat selon un motif et comporte une fonction d'inhibition de la perméation d'un solvant dans une encre, et
une partie hydrophile (4) qui est une partie image formée sur une surface du substrat (2) au niveau d'une partie d'ouverture de la couche empêchant la perméation de solvant hydrophobe (3) et plus hydrophile que la couche empêchant la perméation de solvant hydrophobe (3).

2. Plaque d'impression (1) selon la revendication 1, **caractérisée en ce que** le corps élastique est du caoutchouc silicone, du caoutchouc acrylique, du caoutchouc uréthane, du caoutchouc fluoré, du caoutchouc polysulfide, du caoutchouc éthylène-propylène, du caoutchouc nitrile, du caoutchouc butylique, du caoutchouc chloroprène, du caoutchouc butadiène ou du caoutchouc styrène-butadiène.

3. Plaque d'impression (1) selon la revendication 1 ou 2, **caractérisée en ce qu'**une surface du côté couche empêchant la perméation de solvant hydrophobe (3) du substrat (2) est plate.

4. Plaque d'impression (1) selon la revendication 1 ou 2, **caractérisée en ce que** la surface du substrat (2) comporte une partie concave au niveau de la partie d'ouverture de la couche empêchant la perméation de solvant hydrophobe (3).

5. Procédé de production d'une plaque d'impression (1) pour impression planographique sans eau ou impression en relief comprenant :
une étape de formation d'une couche empêchant la perméation de solvant hydrophobe consistant à former une couche empêchant la perméation de solvant hydrophobe (3) comportant une fonction d'inhibition de la perméation d'un solvant dans une encre sur un substrat (2) contenant un corps élastique dilatable dans un solvant dans une encre ;
une étape de formation d'un motif de réserve consistant à former un motif de réserve (11) sur la couche empêchant la perméation de solvant hydrophobe (3) ;
une étape d'élimination et d'hydrophilisation consistant à éliminer la couche empêchant la perméation de solvant hydrophobe (3) au niveau d'une partie d'ouverture du motif de réserve (11), et à hydrophiliser la surface de substrat exposée pour former une partie hydrophile (4) qui est plus hydrophile que la couche empêchant la perméation de solvant hydrophobe (3) ; et
une étape de pelage du motif de réserve consistant à peler le motif de réserve (11) ;
le procédé permettant d'obtenir une plaque d'impression (1) ayant la partie hydrophile (4) comme une partie image et la surface de la couche empêchant la perméation de solvant hydrophobe (3) comme une partie sans image.

6. Procédé de production d'une plaque d'impression (1) selon la revendication 5, **caractérisé en ce que** le corps élastique est du caoutchouc silicone, du caoutchouc acrylique, du caoutchouc uréthane, du caoutchouc fluoré, du caoutchouc polysulfide, du caoutchouc éthylène-propylène, du caoutchouc nitrile, du caoutchouc butylique, du caoutchouc chloroprène, caoutchouc butadiène ou caoutchouc styrène-butadiène.

7. Procédé de production d'une plaque d'impression (1) selon la revendication 5 ou 6, comprenant en outre une étape de prétraitement consistant à hydrophiliser la surface du substrat avant l'étape de formation de la couche empêchant la perméation de solvant hydrophobe.

8. Procédé de production d'une plaque d'impression (1) selon l'une quelconque des revendications 5 à 7, **caractérisé en ce que** l'étape d'élimination et d'hydrophilisation comprend : une étape d'élimination consistant à éliminer la couche empêchant la perméation de solvant hydrophobe (3) au niveau de la partie d'ouverture du motif de réserve (11) et à éliminer en outre la surface de substrat exposée pour former une partie concave sur la surface de substrat ; et une étape d'hydrophilisation consistant à hydrophiliser la surface exposée du substrat.

9. Procédé de production d'un élément fonctionnel comprenant :
une étape de préparation de plaque d'impression consistant à préparer une plaque d'impression (1) pour impression planographique sans eau comprenant : un substrat (2) contenant un corps élastique dilatable dans un solvant dans une encre, une couche empêchant la perméation de solvant hydrophobe (3) qui est une partie sans image formée sur le substrat (2) selon un motif et qui comporte une fonction d'inhibition de la perméation d'un solvant dans une encre, et d'une partie hydrophile (4) qui est une partie image formée sur une surface du substrat (2) au niveau d'une partie d'ouverture de la couche empêchant la perméation de solvant hydrophobe (3) et plus hydrophile que la couche empêchant la perméation de solvant hydrophobe (3) ;
une surface du côté couche empêchant la perméation de solvant hydrophobe du substrat (2) étant plate ;
une étape de préparation de blanchet consistant à préparer un blanchet (30) comportant un second substrat (31) qui contient un corps élastique dilatable dans un solvant et comporte une région hydrophile (32) sur la surface ;
une étape d'enduction consistant à enduire la surface latérale de la région hydrophile (32) du blanchet (30) d'une solution d'enduction de formation de couche fonctionnelle (35) ;
une première étape de transfert consistant à transférer la solution d'enduction de formation de couche fonctionnelle (35) dans le blanchet (30) uniquement vers la partie hydrophile (4) de la plaque d'impression (1) en mettant le blanchet (30) en contact avec la plaque d'impression (1) par le biais de la solution d'enduction de formation de couche fonctionnelle (35) ; et
une seconde étape de transfert consistant à former une couche fonctionnelle en transférant la solution d'enduction de formation de couche fonctionnelle (35) restant dans le blanchet (30) vers un substrat de formation de couche fonctionnelle (36) ;
la région hydrophile du blanchet étant plus hydrophile que la couche empêchant la perméation de solvant hydrophobe de la plaque d'impression, et étant aussi ou moins hydrophile que la partie hydrophile de la plaque d'impression (1).

10. Procédé de production d'un élément fonctionnel selon la revendication 9, **caractérisé en ce que** le corps élastique est du caoutchouc silicone, du caoutchouc acrylique, du caoutchouc uréthane, du caoutchouc fluoré, du caoutchouc polysulfide, du caoutchouc éthylène-propylène, du caoutchouc nitrile, du caoutchouc butylique, du caoutchouc chloroprène, du caoutchouc butadiène ou du caoutchouc styrène-butadiène.

11. Procédé de production d'un élément fonctionnel selon la revendication 9 ou 10, comprenant en outre une étape d'élimination consistant à transférer la solution d'enduction de formation de couche fonctionnelle (35) au niveau de la partie hydrophile (4) de la plaque d'impression (1) vers un substrat à nettoyer.

12. Appareil d'impression (40) comprenant :
une plaque d'impression (1) pour impression planographique sans eau qui comprend un substrat (2) contenant un corps élastique dilatable dans un solvant dans une encre, une couche empêchant la perméation de solvant hydrophobe (3) qui est une partie sans image formée sur le substrat (2) selon un motif et qui comporte une fonction d'inhibition de la perméation d'un solvant dans une encre, et une partie hydrophile (4) qui est une partie image formée sur une surface du substrat (2) au niveau d'une partie d'ouverture de la couche empêchant la perméation de solvant hydrophobe (3) et plus hydrophile que la couche empêchant la perméation de solvant hydrophobe (3) ;
une surface du côté couche empêchant la perméation de solvant hydrophobe (3) du substrat (2) étant plate ;
un blanchet (30) comportant un second substrat (31) qui contient un corps élastique dilatable dans un solvant et qui comporte une région hydrophile (32) sur la surface, et disposé de manière à pouvoir entrer en contact avec la plaque d'impression (1) ;
une machine d'enduction (41) servant à enduire la surface côté région hydrophile du blanchet (30) d'une encre ;
un élément de montage d'impression (43) qui monte un substrat à soumettre à impression (44) et qui est disposé de manière à pouvoir entrer en contact avec le blanchet (30) ; et
un élément de montage de nettoyage (45) qui monte un substrat à nettoyer (49) et qui est disposé de manière à pouvoir entrer en contact avec la plaque d'impression (1) ;
la région hydrophile (32) du blanchet (30) étant plus hydrophile que la couche empêchant la perméation de solvant hydrophobe (3) de la plaque d'impression (1), et étant aussi ou moins hydrophile que la partie hydrophile (4) de la plaque d'impression (1).

13. Appareil d'impression (40) selon la revendication 12, **caractérisé en ce que** le corps élastique est du caoutchouc silicone, du caoutchouc acrylique, du caoutchouc uréthane, du caoutchouc fluoré, du caoutchouc polysulfide, du caoutchouc éthylène-propylène, du caoutchouc nitrile, du caoutchouc butylique, du caoutchouc chloroprène, du caoutchouc butadiène ou du caoutchouc styrène-butadiène.

14. Appareil d'impression (40) selon la revendication 12 ou 13, **caractérisé en ce que** la plaque d'impression (1), le blanchet (30) et l'élément de montage de nettoyage (45) sont en forme de rouleau ; et l'appareil d'impression (40) comprenant en outre une unité de nettoyage (48) qui comporte l'élément de montage de nettoyage (45) en forme de rouleau, un premier rouleau (46) servant à introduire le substrat à nettoyer (49) qui est long, et un second rouleau (47) servant à enrouler le substrat à nettoyer (49).
